# EUROPEAN PATENT APPLICATION

(11) **EP 4 839 053 A1**
(43) Date of publication of application: **11.11.2026**
(21) Application number: 24915098.8
(22) Date of filing: 16.12.2024
(51) Int. Cl.: H10F 19/85

(54) **SOLAR CELL AND PREPARATION METHOD, AND ELECTRIC DEVICE AND POWER GENERATION DEVICE**

(30) Priority: 05.01.2024 CN 202410021525
(71) Applicant: Contemporary Amperex Future Energy Research Institute (Shanghai) Limited, Shanghai 200241 (CN); Contemporary Amperex Technology Co., Limited, Ningde, Fujian 352100 (CN)
(72) Inventor: JIA, Boyu, Shanghai 200241 (CN); CHEN, Chen, Shanghai 200241 (CN); GU, Shuai, Shanghai 200241 (CN); LI, Yaru, Shanghai 200241 (CN); ZHENG, Yi, Shanghai 200241 (CN); LIU, Tianyu, Shanghai 200241 (CN); YE, Jianing, Shanghai 200241 (CN); AN, Xinyi, Shanghai 200241 (CN); YIN, Zhaoyi, Shanghai 200241 (CN); MENG, Ke, Shanghai 200241 (CN); CHEN, Junchao, Shanghai 200241 (CN); CHEN, Guodong, Shanghai 200241 (CN); GUO, Yongsheng, Shanghai 200241 (CN)
(74) Representative: Gong, Jinping
(86) International application number: PCT/CN2024/139694
(87) International publication number: WO 2025/145883

(57) **Abstract**

This application discloses a solar cell and a preparation method thereof, an electric device, and a power generation device. The solar cell includes: a solar cell body and a protective layer; where the protective layer is disposed on at least one side of the solar cell body, and the protective layer includes at least one stress compensation layer. A neutral plane of the solar cell is located in the functional layer; or a neutral plane of the solar cell is located in the substrate, and a distance between a surface of the functional layer close to the substrate and the neutral plane is less than or equal to 10 µm; or a neutral plane of the solar cell is located in the protective layer, and a distance between a surface of the functional layer close to the protective layer and the neutral plane is less than or equal to 10 µm. In the embodiments of this application, considering interactions between various structure layers of the solar cell, the arrangement of the protective layer allows the formed protective layer to match the solar cell body, such that the neutral plane of the solar cell is close to or located on the easily-failing functional layer, thereby reducing the failure risk of the functional layer and improving the bending resistance of the solar cell.

## Description

This disclosure claims priority to Chinese Patent Application No. 2024100215257 filed on January 5, 2024 and entitled "SOLAR CELL AND PREPARATION METHOD THEREOF, AND ELECTRIC DEVICE", which is incorporated therein by reference in its entirety.

### TECHNICAL FIELD

The present invention relates to the technical field of photovoltaic devices, and in particular, to a solar cell and a preparation method thereof, an electric device, and a power generation device.

### BACKGROUND

Provided in this section is merely background information related to this application and does not necessarily constitute the prior art.

A solar cell directly converts light energy into electrical energy through the photovoltaic effect and is one of the widely used new energy power batteries at present. Currently, substrates of some solar cells adopt flexible materials, which are expected to be integrated with flexible electronic devices and play an important role in fields such as portable electronic products, flexible display devices, and wearable electronic devices. However, electronic devices including flexible solar cells are prone to damage in their functional layers under the action of external forces such as bending, thereby affecting the device performance of solar cells.

### SUMMARY

In view of the technical problems existing in the background, this application provides a solar cell and a preparation method thereof, an electric device, and a power generation device, aiming to improve the bending resistance of the solar cell.

To achieve the above objective, a first aspect of this application provides a solar cell including:
a solar cell body including a substrate and a functional layer that are stacked; where the functional layer includes a plurality of film layers that are stacked; and
a protective layer disposed on at least one side of the solar cell body along a stacking direction of the substrate and the functional layer, where the protective layer includes at least one stress compensation layer; where
a neutral plane of the solar cell is located in the functional layer; or a neutral plane of the solar cell is located in the substrate, and a distance between a surface of the functional layer close to the substrate and the neutral plane is less than or equal to 10 µm; or a neutral plane of the solar cell is located in the protective layer, and a distance between a surface of the functional layer close to the protective layer and the neutral plane is less than or equal to 10 µm.

In the embodiments of this application, considering interactions between various structure layers of the solar cell, the arrangement of the protective layer allows the formed protective layer to match the solar cell body, such that the neutral plane of the solar cell is close to or located on the easily-failing functional layer, thereby reducing the failure risk of the functional layer and improving the bending resistance of the solar cell.

In any embodiment of this application, the protective layer includes a stress compensation body and a first bending portion, the first bending portion is formed by extending at least one stress compensation layer in the stress compensation body, the solar cell body includes a first surface and a side surface surrounding the first surface, the first surface is one of a light receiving surface and a backlight surface of the solar cell body, the stress compensation body is disposed on the first surface, and the first bending portion is disposed on the side surface.

In the embodiments of this application, the arrangement of the first bending portion, on one hand, can reduce the occurrence of edge curling of the stress compensation body, and on the other hand, can improve the protection for the side surface of the solar cell body.

In any embodiment of this application, the protective layer further includes a second bending portion, the second bending portion is formed by extending at least one stress compensation layer in the first bending portion, the solar cell body further includes a second surface disposed opposite to the first surface, the second surface is the other of the light receiving surface and the backlight surface of the solar cell body, and the second bending portion is disposed on the second surface.

In the embodiments of this application, the arrangement of the second bending portion further improves the protection for the second surface of the solar cell body, and the solution of disposing the second bending portion on the entire second surface is conducive to isolating the entire solar cell body from the external environment and improving the service life.

In any embodiment of this application, the second surface has a first region and a second region, the second bending portion is disposed on the second region of the second surface, and the solar cell further includes another protective layer, where the another protective layer is disposed on the first region.

In the embodiments of this application, the arrangement of two differentiated protective layers is conducive to flexibly selecting a matching material of the protective layer according to the preset parameters, and further conducive to making the neutral plane of the solar cell close to or located on the easily-failing functional layer, thereby reducing the failure risk of the functional layer, further improving the bending resistance of the solar cell, and improving the service life of the solar cell.

In any embodiment of this application, the protective layer is disposed on both sides of the solar cell body, the protective layer includes a stress compensation body and a bonding portion, the bonding portion is formed by extending at least one stress compensation layer in the stress compensation body, and a water-oxygen barrier adhesive is disposed between the two bonding portions.

In the embodiments of this application, disposing the protective layer on the two sides of the solar cell body is conducive to flexibly selecting a matching material of the protective layer according to the preset parameters, and further conducive to making the neutral plane of the solar cell close to or located on the easily-failing functional layer, thereby reducing the failure risk of the functional layer. In addition, arranging the bonding portions and directly disposing the water-oxygen barrier adhesive between the two bonding portions further enhance the ability of the solar cell to resist intrusion of moisture and/or oxygen from the external environment.

In any embodiment of this application, a gap is provided between the water-oxygen barrier adhesive and the solar cell body.

In the embodiments of this application, the gap provides space for deformation generated by the solar cell during bending, thereby further improving the bending resistance of the solar cell.

In any embodiment of this application, a width of the gap is 0.1 cm to 1 cm.

In the embodiments of this application, within the above width range, appropriate space is provided for deformation generated by the solar cell during bending, thereby improving the bending resistance of the solar cell.

In any embodiment of this application, the film layer includes a substrate and a functional layer disposed on the substrate, and the neutral plane is located in the functional layer.

In any embodiment of this application, the solar cell includes at least two stress compensation layers, one of which is a viscoelastic layer and the other is an encapsulation layer, and the viscoelastic layer is located between the solar cell body and the encapsulation layer.

In the embodiments of this application, with the viscoelastic layer and the encapsulation layer arranged, adjustment of the position of the neutral plane is more easily achieved.

In any embodiment of this application, the solar cell includes at least four stress compensation layers, the four stress compensation layers are a first viscoelastic layer, a high-elasticity layer, a second viscoelastic layer, and an encapsulation layer that are sequentially disposed, and the first viscoelastic layer farther away from the encapsulation layer is bonded to the solar cell body.

In the embodiments of this application, the above arrangement can make adjacent substrates or film layers or stress compensation layers alleviate the stress they receive and resulting deformation by squeezing the high-elasticity layer, thereby further improving the bending resistance of the solar cell.

In any embodiment of this application, a Young's modulus of the high-elasticity layer is 500 MPa to 5000 MPa.

In the embodiments of this application, within the above Young's modulus range, adjacent substrates or film layers or stress compensation layers alleviate the stress they receive and resulting deformation by squeezing the high-elasticity layer.

In any embodiment of this application, a thickness of the high-elasticity layer is 5 µm to 200 µm.

In the embodiments of this application, within the above thickness range, without significantly increasing the overall thickness of the solar cell, adjacent substrates or film layers or stress compensation layers alleviate the stress they receive and resulting deformation by squeezing the high-elasticity layer.

In any embodiment of this application, the high-elasticity layer includes at least one of silicone and polyurethane elastomer.

In the embodiments of this application, with the specific material provided, the high-elasticity layer using the above materials more easily achieves transfer of the neutral plane from the substrate to the functional layer.

In any embodiment of this application, at room temperature, the first viscoelastic layer has a Young's modulus of 10 kPa to 80 kPa, a creep strain of greater than or equal to 150%, and a creep recovery rate of greater than or equal to 90%; and/or the second viscoelastic layer has a Young's modulus of 10 kPa to 80 kPa, a creep strain of greater than or equal to 150%, and a creep recovery rate of greater than or equal to 90%.

In the embodiments of this application, within the above ranges of the Young's modulus, creep strain, and creep recovery rate, bonding to an adjacent substrate or film layer or stress compensation layer can be achieved, thereby more easily achieving adjustment of the position of the neutral plane.

In any embodiment of this application, a thickness of the first viscoelastic layer is 5 µm to 15 µm; and/or a thickness of the second viscoelastic layer is 5 µm to 15 µm.

In the embodiments of this application, within the above thickness range, without significantly increasing the overall thickness of the solar cell, bonding to an adjacent substrate or film layer or stress compensation layer can be achieved, thereby more easily achieving adjustment of the position of the neutral plane.

In any embodiment of this application, the first viscoelastic layer includes at least one of polyurethane, rubber-based, and polyacrylate-based pressure-sensitive adhesives; and/or the second viscoelastic layer includes at least one of polyurethane and polyacrylate.

In the embodiments of this application, the provided specific materials enable the viscoelastic layer using the above materials to achieve bonding to adjacent substrates or film layers or stress compensation layers, thereby more easily achieving adjustment of the position of the neutral plane.

In any embodiment of this application, the encapsulation layer includes at least one of polymethyl methacrylate (PET), polyethylene naphthalate (PEN), and polycarbonate (PC).

In the embodiments of this application, the provided specific material enables the encapsulation layer using the above material to block the influence of the environmental atmosphere on the solar cell body.

In any embodiment of this application, the functional layer satisfies at least one of conditions (1) to (3):
(1) the functional layer includes a perovskite layer and a carrier transport layer, and the carrier transport layer is located on a side of the perovskite layer and configured to transport carriers;
(2) the functional layer includes a first electrode layer, a first carrier transport layer, a perovskite layer, a second carrier transport layer, and a second electrode layer that are sequentially stacked; the first electrode layer is disposed on the substrate and is a transparent conductive oxide thin film; and the first carrier transport layer is a hole transport layer and the second carrier transport layer is an electron transport layer, or the first carrier transport layer is an electron transport layer and the second carrier transport layer is a hole transport layer; and
(3) the functional layer includes an all-perovskite tandem solar cell functional layer.

In a second aspect, an embodiment of this application provides a method for preparing a solar cell, including:
providing a solar cell body, where the solar cell body includes a substrate and a functional layer that are stacked; and the functional layer includes a plurality of film layers that are stacked;
disposing a protective layer on at least one side of the solar cell body along a stacking direction of the substrate and the functional layer, where the protective layer includes at least one stress compensation layer; where
a neutral plane of the solar cell is located in the functional layer; or a neutral plane of the solar cell is located in the substrate, and a distance between a surface of the functional layer close to the substrate and the neutral plane is less than or equal to 10 µm; or a neutral plane of the solar cell is located in the protective layer, and a distance between a surface of the functional layer close to the protective layer and the neutral plane is less than or equal to 10 µm.

In the embodiments of this application, considering interactions between various structure layers of the solar cell, such that the formed protective layer matches the solar cell body, and the neutral plane of the solar cell is close to or located on the easily-failing functional layer, thereby reducing the failure risk of the functional layer and improving the bending resistance of the solar cell.

In any embodiment of this application, the step of disposing a protective layer on at least one side of the solar cell body includes:
disposing the protective layer on at least one side of the solar cell body according to preset parameters, where the protective layer includes at least one stress compensation layer, and the preset parameters include a thickness of each stress compensation layer and a Young's modulus of a stress compensation material for forming the stress compensation layer; where
the method for determining the preset parameters includes:
   determining the preset parameters according to attribute parameters of the solar cell body and a position parameter of the neutral plane, where the attribute parameters include a thickness of the substrate and a Young's modulus of a substrate material for forming the substrate, and a thickness of each film layer and a Young's modulus of a film layer material for forming the film layer, and the position parameter includes a distance between the neutral plane and a side of the stress compensation layer farther away from the neutral plane.

The embodiments of this application determine the preset parameters of the protective layer through the attribute parameters of the solar cell body and the position parameter of the neutral plane, such that the formed protective layer matches the solar cell body, and the neutral plane of the solar cell formed by the protective layer and the solar cell body is close to or located on the easily-failing functional layer, thereby reducing the failure risk of the functional layer and improving the bending resistance of the solar cell.

In any embodiment of this application, the preset parameters further include a Poisson's ratio of the stress compensation material for forming the stress compensation layer, and the attribute parameters further include a Poisson's ratio of the substrate material for forming the substrate and a Poisson's ratio of the film layer material for forming each film layer.

The embodiments of this application consider the influence of lateral deformation of various structure layers on the position parameter of the neutral plane, so as to improve the accuracy of adjustment of the position of the neutral plane.

In any embodiment of this application, the protective layer includes a stress compensation body and a first bending portion; the first bending portion is formed by extending the stress compensation body, the solar cell body includes a first surface and a side surface surrounding the first surface, the first surface is one of a light receiving surface and a backlight surface of the solar cell body, and the step of disposing the protective layer on at least one side of the solar cell body according to preset parameters includes:
disposing the stress compensation body on the first surface according to the preset parameters, and
bending the first bending portion to the side surface; or
disposing the first bending portion on the side surface according to the preset parameters, and
bending the stress compensation body to the first surface.

In the embodiments of this application, disposing the protective layer on the first surface and the side surface of the solar cell body according to the preset parameters not only improves the bending resistance of the solar cell, but also improves the protection degree for the side surface of the solar cell, thereby further extending the service life of the solar cell.

In any embodiment of this application, the protective layer further includes a second bending portion, the second bending portion is formed by extending the first bending portion, the solar cell body further includes a second surface disposed opposite to the first surface, and the second surface is the other of the light receiving surface and the backlight surface of the solar cell body, where
after the step of bending the first bending portion to the side surface, further including: bending the second bending portion to the second surface; or
after the step of disposing the first bending portion on the side surface, further including: bending the second bending portion to the second surface; or
the step of disposing the first bending portion on the side surface is: disposing the second bending portion on the second surface, and bending the first bending portion to the side surface.

In the embodiments of this application, disposing the protective layer on the first surface, the side surface, and the second surface of the solar cell body according to the preset parameters not only improves the bending resistance of the solar cell, but also further improves the protection degree for the second surface of the solar cell, thereby extending the service life of the solar cell.

In any embodiment of this application, the protective layer is disposed on both sides of the solar cell body, the protective layer includes a stress compensation body and a bonding portion, the bonding portion is formed by extending at least one stress compensation layer in the stress compensation body, the preset parameters include a first sub-preset parameter and a second sub-preset parameter, and the step of disposing the protective layer on at least one side of the solar cell body according to preset parameters includes:
disposing one of the protective layers on one side of the solar cell body according to the first sub-preset parameter;
disposing the other of the protective layers on the other side of the solar cell body according to the second sub-preset parameter; and
disposing a water-oxygen barrier adhesive between the two bonding portions, where the first sub-preset parameter and the second sub-preset parameter are different.

In the embodiments of this application, the protective layers are disposed on two sides of the solar cell body respectively according to different preset parameters, such that parameters of the protective layers on two sides of the solar cell body are differentiated, thereby making the neutral plane of the solar cell close to or located on the easily-failing functional layer, reducing the failure risk of the functional layer, improving the bending resistance of the solar cell, and improving the service life of the solar cell.

In any embodiment of this application, in the step of determining the preset parameters according to attribute parameters of the solar cell body and a position parameter of the neutral plane, the distance between the neutral plane and the side of the protective layer farther away from the neutral plane, the thickness of the stress compensation layer, the Young's modulus of the stress compensation material for forming the stress compensation layer, the thickness of the substrate, the Young's modulus of the substrate material for forming the substrate, the thicknesses of the plurality of film layers, and the Young's moduli of the film layer materials for forming the plurality of film layers satisfy: $h = \frac{{\sum }_{i = 1}^{n} {E}_{i} {t}_{i} \left[\left({\sum }_{j = 1}^{i} {t}_{j}\right)-\frac{{t}_{i}}{2}\right]}{{\sum }_{i = 1}^{n} {E}_{i} {t}_{i}} ;$ where
h is the distance between the neutral plane and the side of the protective layer farther away from the neutral plane, i is the i-th layer, n is the number of layers in the entire device structure, t is the thickness of each layer, E is the Young's modulus of the material of each layer, j is a variable, and j=1 indicates that j starts from 1.

The embodiments of this application provide a specific manner of determining the preset parameters of the protective layer. With the above method, the formed protective layer matches the solar cell body. The neutral plane of the solar cell formed by the protective layer and the solar cell body is close to or located on the easily-failing functional layer, thereby reducing the failure risk of the functional layer, improving the bending resistance of the solar cell, and improving the service life of the solar cell. It can be understood that the embodiments of this application provide a specific method for determining the preset parameters of the protective layer, and other methods capable of determining the preset parameters of the protective layer can also be used.

In any embodiment of this application, in the step of determining the preset parameters according to attribute parameters of the solar cell body and a position parameter of the neutral plane,
the preset parameters further include a Poisson's ratio of the stress compensation material for forming the stress compensation layer, and the attribute parameters further include a Poisson's ratio of the substrate material for forming the substrate and a Poisson's ratio of the film layer material for forming each film layer; and
the distance between the neutral plane and the side of the protective layer farther away from the neutral plane, the thickness of the stress compensation layer, the Young's modulus of the stress compensation material for forming the stress compensation layer, the Poisson's ratio of the stress compensation material for forming the stress compensation layer, the thickness of the substrate, the Young's modulus of the substrate material for forming the substrate, the Poisson's ratio of the substrate material for forming the substrate, the thicknesses of the plurality of film layers, the Young's modulus of the film layer material for forming each film layer, and the Poisson's ratio of the film layer material for forming each film layer satisfy: $h = \frac{{\sum }_{i = 1}^{n} {\overline{E}}_{i} {t}_{i} \left[\left({\sum }_{j = 1}^{i} {t}_{j}\right)-\frac{{t}_{i}}{2}\right]}{{\sum }_{i = 1}^{n} {\overline{E}}_{i} {t}_{i}} ;$ ${\overline{E}}_{i} = {E}_{i} \left(1-{ν}_{i}^{2}\right) ;$ where
h is the distance between the neutral plane and the side of the protective layer farther away from the neutral plane, i is the i-th layer, n is the number of layers in the entire device structure, t is the thickness of each layer, E is the Young's modulus of the material of each layer, j is a variable, j=1 indicates that j starts from 1, and v is the Poisson's ratio.

A third aspect of this application provides an electric device including a solar cell prepared by any preparation method provided in the first aspect or any solar cell provided in the second aspect.

A fourth aspect of this application provides a power generation device including a solar cell prepared by any preparation method provided in the first aspect or any solar cell provided in the second aspect.

### BRIEF DESCRIPTION OF DRAWINGS

To more clearly illustrate the technical solutions in the embodiments of this application, the accompanying drawings to be used in the description of the embodiments will be briefly introduced below. Obviously, the accompanying drawings in the following description are only some embodiments of this application. For those of ordinary skill in the art, other drawings can also be obtained based on these drawings without creative efforts.
FIG. 1 is a first schematic structural diagram of a solar cell according to an embodiment of this application;
FIG. 2 is a second schematic structural diagram of a solar cell according to an embodiment of this application;
FIG. 3 is a third schematic structural diagram of a solar cell according to an embodiment of this application;
FIG. 4 is a fourth schematic structural diagram of a solar cell according to an embodiment of this application;
FIG. 5 is a fifth schematic structural diagram of a solar cell according to an embodiment of this application;
FIG. 6 is a schematic diagram of a sixth structure of a solar cell according to an embodiment of this application;
FIG. 7 is a seventh schematic structural diagram of a solar cell according to an embodiment of this application;
FIG. 8 is an eighth schematic structural diagram of a solar cell according to an embodiment of this application;
FIG. 9 is a ninth schematic structural diagram of a solar cell according to an embodiment of this application;
FIG. 10 is a tenth schematic structural diagram of a solar cell according to an embodiment of this application;
FIG. 11 is a schematic structural diagram of an electric device according to an embodiment of this application;
FIG. 12 is a schematic structural diagram of a power generation device according to an embodiment of this application; and
FIG. 13 is a photograph of a solar cell in a comparative example before and after a bending test, with the left figure being taken before the bending test and the right figure being taken after the bending test.

### Description of reference signs in the accompanying drawings:

100. solar cell, 10. solar cell body, 20. protective layer, 11. substrate, 12. functional layer, 121. film layer, 21. stress compensation layer, S. neutral plane, 101. first surface, 102. side surface, 201. stress compensation body, 202. first bending portion, 203. second bending portion, 103. second surface, A1. first region, A2. second region, 204. bonding portion, 30. water-oxygen barrier adhesive, 211. viscoelastic layer, 212. encapsulation layer, 213. high-elasticity layer, 2111. first viscoelastic layer, 2112. second viscoelastic layer, 2113. third viscoelastic layer, 2121. first encapsulation layer, 2122. second encapsulation layer, 1000. electric device, and 2000. power generation device.

### DESCRIPTION OF EMBODIMENTS

This application will be further described below in conjunction with specific embodiments. It should be understood that these specific embodiments are only for illustrating this application and not for limiting the scope of this application.

For brevity, only some numerical ranges are specifically disclosed therein. However, any lower limit can be combined with any upper limit to form a range not explicitly recited; and any lower limit can be combined with other lower limits to form a range not explicitly recited. Similarly, any upper limit can be combined with any other upper limit to form a range not explicitly recited. In addition, each individually disclosed point or single numerical value can itself be used as a lower limit or upper limit to be combined with any other point or single numerical value or combined with other lower limits or upper limits to form a range not explicitly recited.

In the description herein, unless otherwise specified, the term "or (or)" is inclusive. That is, the phrase "A or (or) B" means "A, B, or both A and B". More specifically, any one of the following cases satisfies the condition "A or B": A is true (or exists) and B is false (or does not exist); A is false (or does not exist) and B is true (or exists); or both A and B are true (or exist).

In the description herein, it should be noted that, unless otherwise specified, "above" and "below" include the referring number, and "more" as in "one or more" means two or more.

Unless otherwise specified, the terms used in this application have the known meanings generally understood by those skilled in the art. Unless otherwise specified, the values of various parameters mentioned in this application can be measured by various measurement methods commonly used in the art (for example, can be tested according to the methods given in the embodiments of this application).

In recent years, perovskite materials have been widely used in solar cells due to their advantages of low carrier recombination probability, high carrier mobility, and long carrier diffusion length. Perovskite materials are attached to a substrate structure by coating or spin coating to form a perovskite layer. Before the perovskite layer material is formed, a plurality of functional film layers can be pre-formed on the substrate structure. An electrode layer can be pre-formed on the substrate structure; or an electrode layer and a carrier transport layer can be sequentially pre-formed on the substrate structure, where the carrier transport layer is an electron hole layer or a hole transport layer; or an electrode layer, a carrier transport layer, and a passivation layer can be sequentially pre-formed on the substrate structure, where the carrier transport layer is an electron hole layer or a hole transport layer. The material particles of the perovskite layer usually do not have strong interactions with each other. When a perovskite solar cell including a flexible substrate is bent, the perovskite layer is stretched or compressed under the influence of bending. After multiple repeated bends, the perovskite layer is prone to creases, cracks, or even fractures, affecting the device performance of the perovskite solar cell, and in severe cases, even causing device damage. Therefore, improving the bending resistance of solar cells is of great significance.

In the prior art, means of directly improving the performance of film layers or adding protective film layers are usually used to improve the bending resistance of solar cells. However, the above methods ignore the influence of interactions between film layer structures on the bending resistance of solar cells, resulting in poor improvement effects or even opposite effects.

A flexible perovskite solar cell is used as an example. The thickness of a conventional flexible substrate is about 50 µm to 200 µm, while the total thickness of other film layer structures attached to the flexible substrate is about 1 µm. Therefore, in a complete flexible perovskite solar cell, a neutral plane is located on the flexible substrate (at a position about 1/2 of the total film thickness). Film layers farther away from the neutral plane are subject to greater stress during bending and are prone to greater strain, which brings greater failure risk to the film layers or the interfaces of the film layers. In the means of improving the bending resistance of solar cells by directly improving the performance of film layers, since the structure of each film layer of the device has not changed significantly, the position of the neutral plane has not changed significantly, the stress on the film layers on the flexible substrate is not significantly reduced, and the bending resistance of the flexible perovskite solar cell is not significantly improved. Although the means of adding protective film layers has changed the film layer structure of the device, the existing arrangement idea still is to improve the bending resistance of the entire device by improving the characteristics of the protective layer material and designing and preparing the protective layer alone, and ignores the influence of interactions between film layer structures on the bending resistance of the solar cell. This is prone to cause the functional film layers of the flexible perovskite solar cell with the added protective film layers to still be in a region with greater stress, and as a result, the bending resistance of the flexible perovskite solar cell is not significantly improved, or even an opposite effect is caused.

To solve the above technical problems, the embodiments of this application provide a method for preparing a solar cell, which determines preset parameters of a protective layer through attribute parameters of a solar cell body and a position parameter of a neutral plane, and disposes the protective layer on at least one side of the solar cell body according to the determined preset parameters of the protective layer, to improve the bending resistance of the solar cell.

The technical solutions described in the embodiments of this application are applicable to a solar cell and a preparation method thereof, an electric device, and a power generation device. The solar cell disclosed in this application can be used in the field of solar power stations and also in the field of lighting. This is not limited in this application.

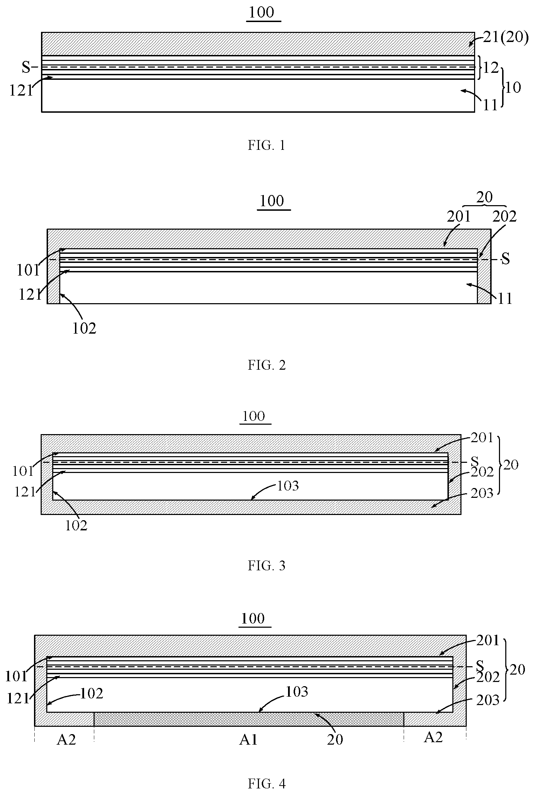

Referring to FIG. 1, FIG. 1 is a schematic structural diagram of a solar cell according to an embodiment of this application.

Referring to FIG. 1, an embodiment of this application provides a solar cell 100. The solar cell 100 includes a solar cell body 10 and a protective layer 20. The solar cell body 10 includes a substrate 11 and a functional layer 12 that are stacked. The functional layer 12 includes a plurality of film layers 121 that are stacked. The protective layer 20 is disposed on at least one side of the solar cell body 10 along a stacking direction of the substrate 11 and the functional layer 12, and the protective layer 20 includes at least one stress compensation layer 21. A neutral plane S of the solar cell 100 is located in the functional layer 12. Alternatively, a neutral plane S of the solar cell 100 is located in the substrate 11, and a distance between a surface of the functional layer 12 close to the substrate 11 and the neutral plane S is less than or equal to 10 µm. Alternatively, a neutral plane S of the solar cell 100 is located in the protective layer 20, and a distance between a surface of the functional layer 12 close to the protective layer 20 and the neutral plane S is less than or equal to 10 µm.

The solar cell 100 refers to a device that directly converts light energy into electrical energy through the photovoltaic effect. Generally, the solar cell 100 includes first-generation solar cells represented by crystalline silicon solar cells, second-generation solar cells represented by thin-film solar cells prepared from direct bandgap semiconductors such as copper indium gallium selenide (CIGS), gallium arsenide (GaAs), and cadmium telluride (CdTe), and third-generation solar cells represented by dye-sensitized solar cells (DSSCs), organic photovoltaic cells (OPVs), and perovskite solar cells (PSCs).

The solar cell body 10 is the main structure forming the solar cell 100.

The substrate 11 is configured to support the functional layer 12. In some embodiments, the substrate 11 is made of a flexible material to improve the flexibility of the solar cell 100, such that the flexible solar cell 100 can be integrated with flexible electronic devices and play an important role in fields such as portable electronic products, flexible display devices, and wearable electronic devices. In some embodiments, the substrate 11 has a certain light transmissivity, enabling external light to reach the functional layer 12 through the substrate 11. In some embodiments, the material of the substrate 11 may include (but is not limited to) organic polymer materials, and further, may be one or more of the following materials mixed in different proportions: including but not limited to polyvinyl alcohol (PVA), polyester (PET), polyimide (PI), polyethylene naphthalate (PEN), and polydimethylsiloxane (PDMS).

The functional layer 12 refers to the main structure that achieves the photovoltaic effect of the solar cell 100. The functional layer 12 includes a plurality of film layers 121, and each film layer 121 can achieve part of the functions of the photovoltaic effect. When the flexible solar cell 100 is bent, the functional layer 12 is stretched or compressed under the influence of bending, and after multiple repeated bends, it is prone to creases, cracks, or even fractures, causing the solar cell 100 to easily fail.

A single perovskite solar cell is used as an example. A plurality of film layers 121 at least include a first electrode layer, a perovskite layer, and a second electrode layer. At least one of the first electrode layer and the second electrode layer is a transparent electrode, such that incident photons can be absorbed by the perovskite layer through the transparent electrode. In some embodiments, one of the first electrode layer and the second electrode layer is a transparent electrode layer, and the other is a metal electrode layer. The provision of the metal electrode layer reduces the resistivity of the solar cell 100 and improves the battery efficiency of the solar cell 100. In some embodiments, the plurality of film layers 121 further include at least one carrier transport layer, disposed between the first electrode layer and the perovskite layer or between the perovskite layer and the second electrode layer, to improve the photoelectric conversion efficiency of the solar cell 100. In some embodiments, the plurality of film layers 121 include two carrier transport layers: an electron transport layer and a hole transport layer respectively, one of which is disposed between the first electrode layer and the perovskite layer, and the other is disposed between the perovskite layer and the second electrode layer, to further improve the photoelectric conversion efficiency of the solar cell 100. In some embodiments, the plurality of film layers 121 include a transparent electrode layer, an electron transport layer, a perovskite layer, a hole transport layer, and a metal electrode layer that are sequentially stacked. It should be noted that the provided single perovskite solar cell can be used alone or applied to devices such as perovskite-perovskite tandem cells, perovskite-crystalline silicon tandem cells, or perovskite-heterojunction tandem cells. This is not limited in this application.

The protective layer 20 is configured to protect the solar cell body 10, and can improve the bending resistance of the solar cell 100 while protecting the solar cell body 10. In some embodiments, the material for forming the protective layer 20 can be a water and oxygen barrier material, which, in addition to the foregoing functions, can also reduce the influence of the external environmental atmosphere on the solar cell body 10.

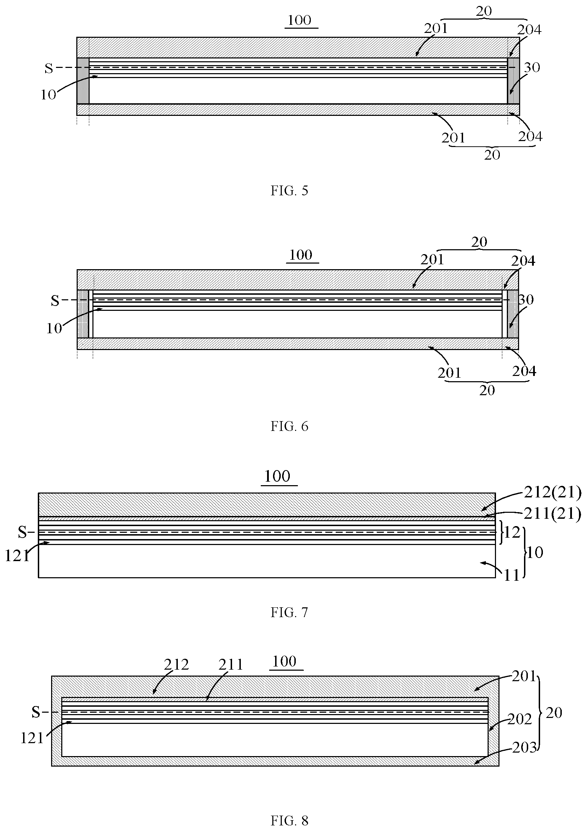

The protective layer 20 can be disposed only on one side of the solar cell body 10 (as shown in FIG. 1), or on two opposite sides of the solar cell body 10 (as shown in FIG. 5), or can wrap the entire solar cell body 10 (as shown in FIG. 3), or can have other common disposing manners in the art, which will not be described in detail in this application.

The stress compensation layer 21 refers to a single-layer sub-structure of the protective layer 20, and is disposed on at least one side of the solar cell body 10. By adding the stress compensation layer 21, the position of the neutral plane S is changed to be located at the functional layer 12 or close to the functional layer 12. When the solar cell body 10 is bent, the bending force on the functional layer 12 can be reduced. The Young's modulus of the film layer material for forming the film layer 121 has a common meaning in the art and can be tested using commonly known equipment and methods in the art. For example, the Young's modulus of the material is tested using the pulse excitation method.

The neutral plane S refers to a plane in the physical structure that is neither under tension nor compression. Since the neutral plane S is not subject to stress, its shape depends only on the properties of the material and the shape of the cross-section. In most cases, the neutral plane S is a plane perpendicular to the main axis. The plane section assumption considers that the position of the neutral plane S on the cross-section is constant, that is, no matter where the cross-section is bent, the position of the neutral plane S remains the same. The plane section assumption is a basic engineering assumption that provides a simple and practical method for calculating bending deformation in material mechanics, and this assumption is feasible for most engineering materials and common bending shapes.

For the solution where the neutral plane S is located at the functional layer 12 or the solution where the neutral plane S is located in the substrate 11 and the distance between the surface of the functional layer 12 close to the substrate 11 and the neutral plane S is less than or equal to a threshold, during bending of the solar cell 100, the functional layer 12 is subjected to small stress and is not prone to failure during bending. Therefore, the bending resistance of the solar cell 100 can be effectively improved.

In the embodiments of this application, considering interactions between various structure layers of the solar cell 100, the arrangement of the protective layer 20 allows the formed protective layer 20 to match the solar cell body 10, such that the neutral plane S of the solar cell 100 is close to or located on the easily-failing functional layer 12, thereby reducing the failure risk of the functional layer 12 and improving the bending resistance of the solar cell 100.

It should be noted that the solar cell body 10 includes a plurality of battery modules arranged in an array, and each battery module includes a plurality of battery cells. The protective layer 20 can cover the entire solar cell body 10 or be disposed corresponding to the battery modules one to one.

Referring to FIG. 2, FIG. 2 is a second schematic structural diagram of a solar cell according to an embodiment of this application.

Referring to FIG. 2, a difference between the solar cell 100 provided by this embodiment of this application and the solar cell 100 provided by the embodiment shown in FIG. 1 lies in that: in the solar cell 100 provided by this embodiment of this application, the solar cell body 10 includes a first surface 101 and a side surface 102 surrounding the first surface 101, and the first surface 101 is one of a light receiving surface and a backlight surface of the solar cell body 10. The protective layer 20 includes a stress compensation body 201 and a first bending portion 202, the first bending portion 202 is formed by extending at least one stress compensation layer 21 in the stress compensation body 201, the stress compensation body 201 is disposed on the first surface 101, and the first bending portion 202 is disposed on the side surface 102.

In some embodiments, the first surface 101 is the backlight surface of the solar cell body 10, and the stress compensation body 201 is disposed on the first surface 101 of the solar cell body 10. In some embodiments, the stress compensation body 201 has adhesiveness. The stress compensation body 201 can be disposed on the first surface 101 by pasting, or the stress compensation body 201 can be disposed on the first surface 101 by other manner such as hot pressing, which can be specifically arranged as required. In other embodiments, the first surface 101 can alternatively be the light receiving surface of the solar cell body 10.

In some embodiments, the thickness of the first bending portion 202 can be the same as the thickness of the stress compensation body 201 to simplify the process.

In some embodiments, the thickness of the first bending portion 202 can be different from the thickness of the stress compensation body 201. That is, the first bending portion 202 can be formed by extending part of the stress compensation layers 21 in the stress compensation body 201 to reduce the layer thickness of the side surface 102 of the solar cell 100. Alternatively, the first bending portion 202 can be formed by adding other layers to the extension region of the stress compensation body 201, such as a heat conduction layer and a hydrophobic layer, so as to add other functions to the side surface 102 of the solar cell 100, such as a heat conduction function and a hydrophobic function. In some embodiments, the first bending portion 202 bent to the side surface 102 can cover the entire side surface 102 or part of the side surface 102.

The stress compensation body 201 is configured to achieve the main function of the stress compensation layer 21, specifically, to reduce the bending force on the functional layer 12 when the solar cell body 10 is bent. The first bending portion 202 is configured to further protect the side surface 102 of the solar cell body 10. The first bending portion 202 can be disposed on the entire side surface 102 or part of the side surface 102. This embodiment of this application provides a solution in which the first bending portion 202 is disposed on the entire side surface 102.

In the embodiments of this application, the arrangement of the first bending portion 202, on one hand, can reduce the occurrence of edge curling of the stress compensation body 201, and on the other hand, can improve the protection for the side surface 102 of the solar cell body 10.

Referring to FIG. 3, FIG. 3 is a third schematic structural diagram of a solar cell according to an embodiment of this application.

Referring to FIG. 3, a difference between the solar cell 100 provided by this embodiment of this application and the solar cell 100 provided by the embodiment shown in FIG. 2 lies in that: the protective layer 20 of the solar cell 100 provided by this embodiment of this application further includes a second bending portion 203, and the second bending portion 203 is formed by extending at least one stress compensation layer 21 from the first bending portion 202. The solar cell body 10 further includes a second surface 103 disposed opposite to the first surface 101. The second surface 103 is the other of the light receiving surface and the backlight surface of the solar cell body 10. The second bending portion 203 is disposed on the second surface 103.

The second bending portion 203 is configured to further improve the protection degree for the solar cell body 10, and to match the stress compensation body 201, thereby further improving the bending resistance of the solar cell 100. The second bending portion 203 can be disposed on the entire second surface 103 or part of the second surface 103. This embodiment of this application provides a solution in which the second bending portion 203 is disposed on the entire second surface 103.

It should be noted that the stress compensation body 201, the first bending portion 202, and the second bending portion 203 can be made of the same material to simplify the process; or can be made of different materials. Different materials can be preset for the stress compensation body 201, the first bending portion 202, and the second bending portion 203 according to the size of the solar cell body 10 in advance. In bending, the protective layer 20 is disposed on each surface of the solar cell body 10 according to the preset bending scheme, which facilitates material customizing as required.

In the embodiments of this application, the arrangement of the second bending portion 203 further improves the protection for the second surface 103 of the solar cell body 10, and the solution of disposing the second bending portion 203 on the entire second surface 103 is conducive to isolating the entire solar cell body 10 from the external environment and improving the service life.

In addition, the second bending portion 203 can cover only part of the second surface 103, that is, the coverage region is the edge position of the second surface 103, to alleviate the situation where the edge of the first bending portion 202 curls when only the first bending portion 202 is provided, thereby increasing the overall reliability of the protective layer 20.

Referring to FIG. 4, FIG. 4 is a fourth schematic structural diagram of a solar cell according to an embodiment of this application.

Referring to FIG. 4, a difference between the solar cell 100 provided by this embodiment of this application and the solar cell 100 provided by the embodiment shown in FIG. 3 lies in that: the second surface 103 of the solar cell 100 provided by this embodiment of this application has a first region A1 and a second region A2. The second bending portion 203 is disposed on the second region A2 of the second surface 103, and the solar cell 100 further includes another protective layer 20, where the another protective layer 20 is disposed on the first region A1.

This embodiment of this application provides a solution in which the second bending portion 203 is disposed on part of the second surface 103. The two protective layers 20 of the solar cell 100 can be made of the same or different materials, and their thicknesses can be the same or different, which are specifically set according to the preset parameters.

In the embodiments of this application, the arrangement of two differentiated protective layers 20 is conducive to flexibly selecting a matching material of protective layers 20 according to the preset parameters, and further conducive to making the neutral plane S of the solar cell 100 close to or located on the easily-failing functional layer 12, thereby reducing the failure risk of the functional layer 12, further improving the bending resistance of the solar cell 100, and improving the service life of the solar cell 100.

Referring to FIG. 5, FIG. 5 is a fifth schematic structural diagram of a solar cell according to an embodiment of this application.

Referring to FIG. 5, a difference between the solar cell 100 provided by this embodiment of this application and the solar cell 100 provided by the embodiment shown in FIG. 1 lies in that: the protective layer 20 is disposed on both sides of the solar cell body 10 of the solar cell 100 provided by this embodiment of this application, and the protective layer 20 includes a stress compensation body 201 and a bonding portion 204. The bonding portion 204 is formed by extending at least one stress compensation layer 21 in the stress compensation body 201. A water-oxygen barrier adhesive 30 is disposed between the two bonding portions 204.

The water-oxygen barrier adhesive 30 refers to an adhesive structure capable of resisting intrusion of moisture and/or oxygen from the external environment into the solar cell body 10. In some embodiments, the bonding portion 204 is disposed on the side surface 102 of the solar cell body 10, one end of which is bonded to the bonding portion 204 of one protective layer 20, and the other end is bonded to the bonding portion 204 of the other protective layer 20. In some embodiments, the water-oxygen barrier adhesive 30 is disposed on the entire side surface 102 of the solar cell body 10, and together with the arrangement of the protective layer 20, resists the water-oxygen exchange between the solar cell body 10 and the outside, thereby improving the protection degree for the solar cell body 10.

The protective layers 20 on two sides of the solar cell body 10 can be made of the same or different materials, and their thicknesses can be the same or different, which are specifically set according to preset parameters.

In the embodiments of this application, disposing the protective layers 20 on the two sides of the solar cell body 10 is conducive to flexibly selecting a matching material of protective layers 20 according to the preset parameters, and further conducive to making the neutral plane S of the solar cell 100 close to or located on the easily-failing functional layer 12, thereby reducing the failure risk of the functional layer 12. In addition, arranging the bonding portions 204 and directly disposing the water-oxygen barrier adhesive 30 between the two bonding portions 204 further enhance the ability of the solar cell 100 to resist intrusion of moisture and/or oxygen from the external environment.

Referring to FIG. 6, FIG. 6 is a schematic diagram of a sixth structure of a solar cell according to an embodiment of this application.

Referring to FIG. 6, a difference between the solar cell 100 provided by this embodiment of this application and the solar cell 100 provided by the embodiment shown in FIG. 5 lies in that: a gap is provided between the water-oxygen barrier adhesive 30 of the solar cell 100 provided by this embodiment of this application and the solar cell body 10.

The embodiments of this application provide space for deformation generated by the solar cell 100 during bending through the gap, further improving the bending resistance of the solar cell 100.

In any embodiment of this application, a width of the gap is 0.1 cm to 1 cm.

In some embodiments, the width of the gap can be 0.1 cm, 0.2 cm, 0.3 cm, 0.4 cm, 0.5 cm, 0.6 cm, 0.7 cm, 0.8 cm, 0.9 cm, 1 cm, or a range composed of any two of the above values. For example, it can be 0.1 cm to 0.4 cm, 0.3 cm to 0.7 cm, 0.6 cm to 0.8 cm, 0.7 cm to 1 cm, or the like.

In the embodiments of this application, within the above width range, appropriate space is provided for deformation generated by the solar cell 100 during bending, thereby improving the bending resistance of the solar cell 100.

Referring to FIG. 7, FIG. 7 is a seventh schematic structural diagram of a solar cell according to an embodiment of this application.

Referring to FIG. 7, a difference between the solar cell 100 provided by this embodiment of this application and the solar cell 100 provided by the embodiment shown in FIG. 1 lies in that: the solar cell 100 provided by this embodiment of this application includes at least two stress compensation layers 21, one of which is a viscoelastic layer 211 and the other is an encapsulation layer 212, and the viscoelastic layer 211 is located between the solar cell body 10 and the encapsulation layer 212.

The viscoelastic layer 211 refers to a layer structure having adhesiveness and elasticity, configured to bond to the solar cell body 10, and for achieving bonding of the encapsulation layer 212 to the solar cell body 10 through the viscoelastic layer 211. With the viscoelastic layer 211 disposed, adjustment of the position of the neutral plane S is easier. Generally, the viscoelastic layer 211 has a Young's modulus of 10 kPa to 80 kPa, and therefore has great flexibility, making it easier to achieve greater neutral plane position adjustment with a smaller thickness. The encapsulation layer 212 has barrier properties for blocking the influence of the environmental atmosphere on the solar cell body 10. In some embodiments, the Young's modulus of the encapsulation layer 212 is in the range of 1000 MPa to 8000 MPa, and the Poisson's ratio thereof is 0 to 0.5. It can be understood that, the viscoelastic layer 211 has adhesiveness and flexibility and therefore is easier to match with other stress compensation layers 21, to better adjust the position of the neutral plane S in the solar cell 100, and to better improve the protection degree for the solar cell body 10.

In the embodiments of this application, with the viscoelastic layer 211 and the encapsulation layer 212 arranged, adjustment of the position of the neutral plane S is more easily achieved.

Referring to FIG. 8, FIG. 8 is an eighth schematic structural diagram of a solar cell according to an embodiment of this application.

Referring to FIG. 8, a difference between the solar cell 100 provided by this embodiment of this application and the solar cell 100 provided by the embodiment shown in FIG. 7 lies in that: the protective layer 20 of the solar cell 100 provided by this embodiment of this application includes a stress compensation body 201, a first bending portion 202, and a second bending portion 203, where the stress compensation body 201 is disposed on the entire first surface 101. The stress compensation body 201 of this embodiment is formed by at least two stress compensation layers 21, one of which is a viscoelastic layer 211 and the other is an encapsulation layer 212. The first bending portion 202 is formed by extending the encapsulation layer 212 forming the stress compensation body 201 and is disposed on the entire side surface 102. The second bending portion 203 is formed by extending the encapsulation layer 212 forming the first bending portion 202 and is disposed on the entire second surface 103.

In the embodiments of this application, with the viscoelastic layer 211 and the encapsulation layer 212 arranged, adjustment of the position of the neutral plane S is more easily achieved.

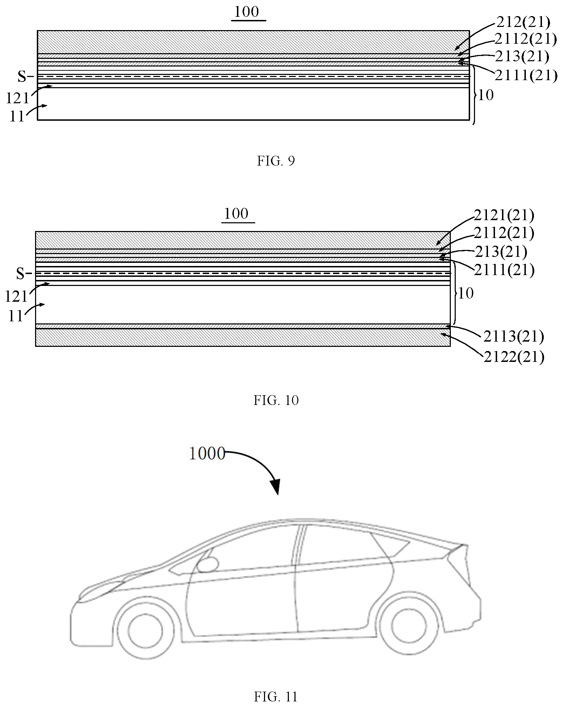

Referring to FIG. 9, FIG. 9 is a ninth schematic structural diagram of a solar cell according to an embodiment of this application.

Referring to FIG. 9, a difference between the solar cell 100 provided by this embodiment of this application and the solar cell 100 provided by the embodiment shown in FIG. 1 lies in that: the solar cell 100 includes at least four stress compensation layers 21, the four stress compensation layers 21 are a first viscoelastic layer 2111, a high-elasticity layer 213, a second viscoelastic layer 2112, and an encapsulation layer 212 that are sequentially disposed, and the first viscoelastic layer 2111 is bonded to the solar cell body 10.

The high-elasticity layer 213 is configured to reduce the overall thickness of the solar cell 100, and can make adjacent substrates 11 or film layers 121 or stress compensation layers 21 alleviate the stress they receive and resulting deformation by squeezing the high-elasticity layer 213. In some embodiments, the high-elasticity layer 213 refers to a film layer having a larger Young's modulus than the first viscoelastic layer 2111 and the second viscoelastic layer 2112, making it easier to achieve transfer of the neutral plane S from the substrate 11 to the functional layer 12. The viscoelastic layer 211 is disposed on both opposite sides of the high-elasticity layer 213, which can achieve adhesion between the high-elasticity layer 213 and the solar cell body 10 and adhesion between the high-elasticity layer 213 and the encapsulation layer 212.

In the embodiments of this application, the above arrangement can make adjacent substrates 11 or film layers 121 or stress compensation layers 21 alleviate the stress they receive and resulting deformation by squeezing the high-elasticity layer 213, thereby further improving the bending resistance of the solar cell 100.

Referring to FIG. 10, FIG. 10 is a tenth schematic structural diagram of a solar cell according to an embodiment of this application.

Referring to FIG. 10, a difference between the solar cell 100 provided by this embodiment of this application and the solar cell 100 provided by the embodiment shown in FIG. 1 lies in that: the solar cell 100 includes at least six stress compensation layers 21. Four of the stress compensation layers 21 are a first viscoelastic layer 2111, a high-elasticity layer 213, a second viscoelastic layer 2112, and a first encapsulation layer 2121 that are sequentially disposed, and are disposed on one side of the solar cell body 10. The first viscoelastic layer 2111 is bonded to the solar cell body 10.

The other two stress compensation layers 21 are sequentially stacked on the other side of the solar cell body 10 to form another protective layer 20. The two stress compensation layers 21 are sequentially a third viscoelastic layer 2113 and a second encapsulation layer 2122, where the third viscoelastic layer 2113 is bonded to the solar cell body 10.

In the embodiments of this application, disposing the protective layer 20 on both sides of the solar cell body 10 further improves the bending resistance of the solar cell 100.

In any embodiment of this application, a Young's modulus of the high-elasticity layer 213 is 500 MPa to 5000 MPa.

In some embodiments, the Young's modulus of the high-elasticity layer 213 is 500 MPa, 800 MPa, 1000 MPa, 1200 MPa, 1500 MPa, 1800 MPa, 2000 MPa, 2200 MPa, 2500 MPa, 2800 MPa, 3000 MPa, 3200 MPa, 3500 MPa, 4000 MPa, 4200 MPa, 4500 MPa, 4800 MPa, 5000 MPa, or a range composed of any two of the above values. For example, it can be 500 MPa to 1500 MPa, 1200 MPa to 2500 MPa, 2200 MPa to 3500 MPa, 3000 MPa to 5000 MPa, or the like.

In the embodiments of this application, within the above Young's modulus range, adjacent substrates 11 or film layers 121 or stress compensation layers 21 alleviate the stress they receive and resulting deformation by squeezing the high-elasticity layer 213.

In any embodiment of this application, a thickness of the high-elasticity layer 213 is 5 µm to 200 µm.

In some embodiments, the thickness of the high-elasticity layer 213 is 5 µm, 20 µm, 30 µm, 40 µm, 50 µm, 60 µm, 70 µm, 80 µm, 90 µm, 100 µm, 110 µm, 120 µm, 130 µm, 140 µm, 150 µm, 160 µm, 170 µm, 160 µm, 170 µm, 180 µm, 190 µm, 200 µm, or a range composed of any two of the above values. For example, it can be 5 µm to 50 µm, 40 µm to 100 µm, 80 µm to 150 µm, 140 µm to 200 µm, or the like.

In the embodiments of this application, within the above thickness range, without significantly increasing the overall thickness of the solar cell 100, adjacent substrates 11 or film layers 121 or stress compensation layers 21 alleviate the stress they receive and resulting deformation by squeezing the high-elasticity layer 213.

In any embodiment of this application, the high-elasticity layer 213 includes at least one of silicone and polyurethane elastomer.

In some embodiments, the silicone includes a polydimethylsiloxane component.

In the embodiments of this application, with the specific material provided, the high-elasticity layer 213 using the above materials more easily achieves transfer of the neutral plane S from the substrate 11 to the functional layer 12.

In any embodiment of this application, at room temperature, the first viscoelastic layer 2111 has a Young's modulus of 10 kPa to 80 kPa, a creep strain of greater than or equal to 150%, and a creep recovery rate of greater than or equal to 90%. In any embodiment of this application, at room temperature, the second viscoelastic layer 2112 has a Young's modulus of 10 kPa to 80 kPa, a creep strain of greater than or equal to 150%, and a creep recovery rate of greater than or equal to 90%.

Room temperature is also called normal temperature or ambient temperature, generally defined as 25°C. In engineering in China, room temperature is defined at 20°C, which is the temperature in spring and autumn in most places in China, such as circulating water temperature (natural water temperature). The Young's modulus, creep strain, and creep recovery rate of the first viscoelastic layer 2111 and the second viscoelastic layer 2112 have common meanings in the art and can be tested using commonly known equipment and methods in the art. In some embodiments, the above three parameters can all be tested using a rheometer.

The method for testing Young's modulus using a rheometer is: measuring a dynamic response of a sample by oscillating it in a dynamic testing mode of the rheometer. In dynamic testing, the sample is placed on a vibrating plate or vibrating string, and the vibrating plate or vibrating string vibrates at a constant frequency and amplitude. The response of the sample can be obtained by measuring the displacement and force on the vibrating plate or vibrating string.

The method for testing creep strain and creep recovery rate using a rheometer is: using the creep testing mode of the rheometer, which studies the creep behavior by measuring the response of the sample over time under constant stress or strain. In creep testing, the sample is placed in a sample chamber of a fixed shape, and the stress or strain in the sample chamber is applied to the sample.

In some embodiments, at room temperature, the Young's modulus of the first viscoelastic layer 2111 can be 10 kPa, 15 kPa, 20 kPa, 25 kPa, 30 kPa, 35 kPa, 40 kPa, 45 kPa, 50 kPa, 55 kPa, 60 kPa, 65 kPa, 70 kPa, 75 kPa, 80 kPa, or a range composed of any two of the above values. For example, it can be 10 kPa to 40 kPa, 20 kPa to 50 kPa, 30 kPa to 60 kPa, 40 kPa to 70 kPa, or the like. At room temperature, the creep strain of the viscoelastic layer 211 can be 150%, 155%, 160%, 165%, 170%, 175%, 180%, 185%, 190%, 195%, 200%, 205%, 210%, 215%, 220%, or a range composed of any two of the above values. For example, it can be 150% to 180%, 160% to 190%, 170% to 200%, 180% to 210%, or the like. At room temperature, the creep recovery rate of the viscoelastic layer 211 can be 90%, 95%, 100%, 105%, 110%, 115%, 120%, 125%, 130%, 135%, 140%, 145%, 150%, 155%, 160%, or a range composed of any two of the above values. For example, it can be 90% to 130%, 100% to 140%, 110% to 150%, 120% to 160%, or the like.

In some embodiments, at room temperature, the Young's modulus of the second viscoelastic layer 2112 can be 10 kPa, 15 kPa, 20 kPa, 25 kPa, 30 kPa, 35 kPa, 40 kPa, 45 kPa, 50 kPa, 55 kPa, 60 kPa, 65 kPa, 70 kPa, 75 kPa, 80 kPa, or a range composed of any two of the above values. For example, it can be 10 kPa to 40 kPa, 20 kPa to 50 kPa, 30 kPa to 60 kPa, 40 kPa to 70 kPa, or the like. At room temperature, the creep strain of the viscoelastic layer 211 can be 150%, 155%, 160%, 165%, 170%, 175%, 180%, 185%, 190%, 195%, 200%, 205%, 210%, 215%, 220%, or a range composed of any two of the above values. For example, it can be 150% to 180%, 160% to 190%, 170% to 200%, 180% to 210%, or the like. At room temperature, the creep recovery rate of the viscoelastic layer 211 can be 90%, 95%, 100%, 105%, 110%, 115%, 120%, 125%, 130%, 135%, 140%, 145%, 150%, 155%, 160%, or a range composed of any two of the above values. For example, it can be 90% to 130%, 100% to 140%, 110% to 150%, 120% to 160%, or the like.

In the embodiments of this application, within the above ranges of the Young's modulus, creep strain, and creep recovery rate, bonding to adjacent substrates 11 or film layers 121 or stress compensation layers 21 can be achieved, thereby more easily achieving adjustment of the position of the neutral plane S.

In any embodiment of this application, a thickness of the first viscoelastic layer 2111 is 5 µm to 15 µm. In any embodiment of this application, a thickness of the second viscoelastic layer 2112 is 5 µm to 15 µm.

In some embodiments, the thickness of the first viscoelastic layer 2111 can be 5 µm, 6 µm, 7 µm, 8 µm, 9 µm, 10 µm, 11 µm, 12 µm, 13 µm, 14 µm, 15 µm, or a range composed of any two of the above values. For example, it can be 5 µm to 12 µm, 6 µm to 13 µm, 7 µm to 14 µm, 8 µm to 15 µm, or the like. In some embodiments, the thickness of the second viscoelastic layer 2112 can be 5 µm, 6 µm, 7 µm, 8 µm, 9 µm, 10 µm, 11 µm, 12 µm, 13 µm, 14 µm, 15 µm, or a range composed of any two of the above values. For example, it can be 5 µm to 12 µm, 6 µm to 13 µm, 7 µm to 14 µm, 8 µm to 15 µm, or the like.

In the embodiments of this application, within the above thickness range, without significantly increasing the overall thickness of the solar cell 100, bonding to an adjacent substrate 11 or film layer 121 or stress compensation layer 21 can be achieved, thereby more easily achieving adjustment of the position of the neutral plane S.

In any embodiment of this application, the first viscoelastic layer 2111 includes at least one of polyurethane and polyacrylate. In any embodiment of this application, the second viscoelastic layer 2112 includes at least one of polyurethane and polyacrylate.

In the embodiments of this application, the provided specific materials enable the viscoelastic layer 211 using the above materials to achieve bonding to adjacent substrates 11 or film layers 121 or stress compensation layers 21, thereby more easily achieving adjustment of the position of the neutral plane S.

In any embodiment of this application, the encapsulation layer 212 includes at least one of polyethylene terephthalate (PET), polyethylene naphthalate (PEN), and polycarbonate (PC).

In the embodiments of this application, the provided specific material enables the encapsulation layer 212 using the above materials to block the influence of the environmental atmosphere on the solar cell body 10.

In any embodiment of this application, the functional layer 12 satisfies at least one of conditions (1) to (3):
(1) The functional layer 12 includes a perovskite layer and a carrier transport layer, and the carrier transport layer is located on a side of the perovskite layer and configured to transport carriers. In some embodiments, a passivation layer is disposed between the perovskite layer and the carrier transport layer.
(2) The functional layer 12 includes a first electrode layer, a first carrier transport layer, a perovskite layer, a second carrier transport layer, and a second electrode layer that are sequentially stacked; the first electrode layer is disposed on the substrate and is a transparent conductive oxide thin film; and the first carrier transport layer is a hole transport layer and the second carrier transport layer is an electron transport layer, or the first carrier transport layer is an electron transport layer and the second carrier transport layer is a hole transport layer.
(3) The functional layer 12 includes an all-perovskite tandem solar cell functional layer.

The perovskite layer is configured to absorb photon energy of sunlight to generate electron-hole pairs, and under the action of a built-in electric field, separate the electron-hole pairs into free electrons and holes. The holes and electrons are collected by two different electrodes respectively, and the two electrodes are connected into a circuit to generate photocurrent. The carrier transport layer refers to a structural layer that transports electrons or holes generated by the perovskite layer excited by photons. The hole transport layer is configured to collect and transport holes to achieve effective separation of electrons and holes. The electron transport layer is also called an electron collection layer, and configured to transport electrons and block electron-hole recombination. The passivation layer is configured to passivate defects in the perovskite layer. The all-perovskite tandem solar cell refers to a solar cell in which two perovskite absorption layers with different bandgaps are stacked, and this tandem solar cell can effectively broaden the absorption spectrum of the battery and reduce thermal relaxation losses. The all-perovskite tandem solar cell functional layer refers to a main structure that achieves the photovoltaic effect in the all-perovskite tandem solar cell.

The solution of the embodiments of this application for adjusting the position of the neutral plane S of the solar cell 100 to improve the bending resistance of the solar cell 100 can be applied to multiple different types of solar cells 100.

To achieve the above objective, a second aspect of this application provides a method for preparing a solar cell, including:
S1: Provide a solar cell body 10, where the solar cell body 10 includes a substrate 11 and a functional layer 12 that are stacked; and the functional layer 12 includes a plurality of film layers 121 that are stacked.
S2: Dispose a protective layer 20 on at least one side of the solar cell body 10 along a stacking direction of the substrate 11 and the functional layer 12, where the protective layer 20 includes at least one stress compensation layer 21.

A neutral plane S of the solar cell 100 is located in the functional layer 12; or a neutral plane S of the solar cell 100 is located in the substrate 11, and a distance between a surface of the functional layer 12 close to the substrate 11 and the neutral plane S is less than or equal to 10 µm; or a neutral plane S of the solar cell 100 is located in the protective layer 20, and a distance between a surface of the functional layer 12 close to the protective layer 20 and the neutral plane S is less than or equal to 10 µm.

In the embodiments of this application, considering interactions between various structure layers of the solar cell 100, such that the formed protective layer 20 matches the solar cell body 10, and the neutral plane S of the solar cell 100 is close to or located on the easily-failing functional layer 12, thereby reducing the failure risk of the functional layer 12 and improving the bending resistance of the solar cell 100.

In any embodiment of this application, the step of "disposing a protective layer 20 on at least one side of the solar cell body 10" in S2 includes:
disposing the protective layer 20 on at least one side of the solar cell body 10 according to preset parameters, where the protective layer 20 includes at least one stress compensation layer 21, and the preset parameters include a thickness of each stress compensation layer 21 and a Young's modulus of a stress compensation material for forming the stress compensation layer 21.

The method for determining the preset parameters includes:
determining the preset parameters according to attribute parameters of the solar cell body 10 and a position parameter of the neutral plane S, where the attribute parameters include a thickness of the substrate 11 and a Young's modulus of a substrate material for forming the substrate 11, and a thickness of each film layer 121 and a Young's modulus of a film layer material for forming the film layer 121, and the position parameter includes a distance between the neutral plane S and a side of the stress compensation layer 21 farther away from the neutral plane S.

The preset parameters refer to parameters for preparing the protective layer 20 that are determined in advance.

The embodiments of this application determine the preset parameters of the protective layer 20 through the attribute parameters of the solar cell body 10 and the position parameter of the neutral plane S, such that the formed protective layer 20 matches the solar cell body 10, and the neutral plane S of the solar cell 100 formed by the protective layer 20 and the solar cell body 10 is close to or located on the easily-failing functional layer 12, thereby reducing the failure risk of the functional layer 12 and improving the bending resistance of the solar cell 100.

In any embodiment of this application, the preset parameters further include a Poisson's ratio of the stress compensation material for forming the stress compensation layer 21, and the attribute parameters further include a Poisson's ratio of the substrate material for forming the substrate 11 and a Poisson's ratio of the film layer material for forming each film layer 121.

The Poisson's ratio of the stress compensation material for forming the stress compensation layer 21 has a well-known meaning in the art and can be tested using known devices and methods in the art. For example, the Poisson's ratio of the material is tested using an optical interferometry method. The embodiments of this application consider the influence of lateral deformation of various structure layers on the position parameter of the neutral plane S, so as to improve the accuracy of adjustment of the position of the neutral plane S.

In some embodiments, the step of disposing the protective layer 20 on at least one side of the solar cell body 10 according to preset parameters in S2 includes:
S211: Dispose the stress compensation body 201 on the first surface 101 according to the preset parameters.
S212: Bend the first bending portion 202 to the side surface 102.

In some embodiments, the stress compensation body 201 can be first disposed on the first surface 101, and then the first bending portion 202 is bent to the side surface 102. Alternatively, the protective layer 20 can be bent in advance such that part of the protective layer 20 is the stress compensation body 201 and the other part is bent to form the first bending portion 202, and then the pre-bent protective layer 20 is disposed on the first surface 101 and the side surface 102 of the solar cell body 10.

It should be noted that the preset parameters of the stress compensation body 201 affect the change in the position parameter of the neutral plane S of the solar cell 100; but the preset parameters of the first bending portion 202 do not affect the change in the position parameter of the neutral plane S of the solar cell 100.

In some embodiments, the step of disposing the protective layer 20 on at least one side of the solar cell body 10 according to preset parameters in S2 includes:
S221: Dispose the first bending portion 202 on the side surface 102 according to the preset parameters.

In some embodiments, the first bending portion 202 has adhesiveness, and the first bending portion 202 can be disposed on the side surface 102 by pasting, or the first bending portion 202 can be disposed on the side surface 102 by other manner such as hot pressing, which is specifically set as needed.

S222: Bend the stress compensation body 201 to the first surface 101.

In some embodiments, the first bending portion 202 can be first disposed on the side surface 102, and then the stress compensation body 201 is bent to the first surface 101. Alternatively, the protective layer 20 can be bent in advance such that part of the protective layer 20 is the stress compensation body 201 and the other part is bent to form the first bending portion 202, and then the pre-bent protective layer 20 is disposed on the first surface 101 and the side surface 102 of the solar cell body 10.

In the embodiments of this application, disposing the protective layer 20 on the first surface 101 and the side surface 102 of the solar cell body 10 according to the preset parameters not only improves the bending resistance of the solar cell 100, but also improves the protection degree for the side surface 102 of the solar cell 100, thereby further extending the service life of the solar cell 100.

In any embodiment of this application, the protective layer 20 further includes a second bending portion 203, the second bending portion 203 is formed by extending the first bending portion 202, the solar cell body 10 further includes a second surface 103 disposed opposite to the first surface 101, and the second surface 103 is the other of the light receiving surface and the backlight surface of the solar cell body 10.

In some embodiments, after the step of bending the first bending portion 202 to the side surface 102 in S212, the method further includes: bending the second bending portion 203 to the second surface 103.

In some embodiments, after the step of disposing the first bending portion 202 on the side surface 102 in S221, the method further includes: bending the second bending portion 203 to the second surface 103.

In some embodiments, the step of disposing the first bending portion 202 on the side surface 102 in S221 is: disposing the second bending portion 203 on the second surface 103, and bending the first bending portion 202 to the side surface 102.

The manner of disposing the protective layer 20 on the solar cell body 10 can be various, which is not limited in this application, as long as the protective layer 20 can be disposed on the surface of the solar cell body 10. Specifically, in some embodiments, the protective layer 20 includes a stress compensation body 201, a first bending portion 202, and a second bending portion 203 that are sequentially connected. When the protective layer 20 is disposed on the solar cell body 10, the stress compensation body 201, the first bending portion 202, and the second bending portion 203 can be sequentially disposed on the solar cell body 10 in the order listed; or the first bending portion 202, the second bending portion 203, and the stress compensation body 201 can be sequentially disposed on the solar cell body 10 in the order listed; or the second bending portion 203, the first bending portion 202, and the stress compensation body 201 can be sequentially disposed on the solar cell body 10 in the order listed.

In some embodiments, the first surface 101 is the backlight surface of the solar cell body 10, and the second surface 103 is the light receiving surface of the solar cell body 10. In other embodiments, the first surface 101 can alternatively be the light receiving surface of the solar cell body 10, and the second surface 103 is the backlight surface of the solar cell body 10. The stress compensation body 201 is disposed on the first surface 101, and the second bending portion 203 is disposed on the second surface 103. The thickness of the second bending portion 203 is less than the thickness of the stress compensation body 201, or the thickness of the second bending portion 203 is equal to the thickness of the stress compensation body 201 and the Young's modulus of the second bending portion 203 is greater than the Young's modulus of the stress compensation body 201. Alternatively, the thickness of the second bending portion 203 is less than the thickness of the stress compensation body 201 and the Young's modulus of the second bending portion 203 is greater than the Young's modulus of the stress compensation body 201, which can make the neutral plane S of the solar cell 100 formed by the protective layer 20 and the solar cell body 10 closer to or located on the easily-failing functional layer 12, thereby further improving the bending resistance of the solar cell 100.

In the embodiments of this application, disposing the protective layer 20 on the first surface 101, the side surface 102, and the second surface 103 of the solar cell body 10 according to the preset parameters not only improves the bending resistance of the solar cell 100, but also further improves the protection degree for the second surface 103 of the solar cell 100, thereby extending the service life of the solar cell 100.

In addition, the second bending portion 203 can cover only part of the second surface 103, that is, the coverage region is the edge position of the second surface 103, to alleviate the situation where the edge of the first bending portion 202 curls when only the first bending portion 202 is provided, thereby increasing the overall reliability of the protective layer 20.

In any embodiment of this application, the protective layer 20 is disposed on both sides of the solar cell body 10, the protective layer 20 includes a stress compensation body 201 and a bonding portion 204, the bonding portion 204 is formed by extending at least one stress compensation layer 21 in the stress compensation body 201, and the preset parameters include a first sub-preset parameter and a second sub-preset parameter.

In some embodiments, the bonding portion 204 is configured to bond other film layers 121. In some embodiments, the bonding portion 204 can be formed by extending only one stress compensation layer 21, or can be formed by extending several stress compensation layers 21. In some embodiments, the extension direction of the bonding portion 204 is the same as the extension direction of the stress compensation layer 21.

In S2, the step of disposing the protective layer 20 on at least one side of the solar cell body 10 according to preset parameters includes:
S231: Dispose one of the protective layers 20 on one side of the solar cell body 10 according to the first sub-preset parameter.
S232: Dispose the other of the protective layers 20 on the other side of the solar cell body 10 according to the second sub-preset parameter.
S233: Dispose a water-oxygen barrier adhesive 30 between the two bonding portions 204, where the first sub-preset parameter and the second sub-preset parameter are different.

In some embodiments, the difference between the first sub-preset parameter and the second sub-preset parameter makes the designs of the protective layers 20 on two opposite sides of the solar cell body 10 differentiated, such that the neutral plane S moves from the initial position toward or into the functional layer 12, thereby improving the bending resistance of the solar cell 100 and extending the service life of the solar cell 100. For example, a protective layer A is disposed on the light receiving surface of the solar cell body 10 according to the first sub-preset parameter, and a protective layer B is disposed on the backlight surface of the solar cell body 10 according to the second sub-preset parameter. The thickness of the stress compensation body 201 of the protective layer A is less than the thickness of the stress compensation body 201 of the protective layer B, and/or the Young's modulus of the stress compensation body 201 of the protective layer A is greater than the Young's modulus of the stress compensation body 201 of the protective layer B.

In the embodiments of this application, the protective layers 20 are disposed on two sides of the solar cell body 10 respectively according to different preset parameters, such that parameters of the protective layers 20 on two sides of the solar cell body 10 are differentiated, thereby making the neutral plane S of the solar cell 100 close to or located on the easily-failing functional layer 12, reducing the failure risk of the functional layer 12, improving the bending resistance of the solar cell 100, and improving the service life of the solar cell 100.

In any embodiment of this application, in the method for determining the preset parameters in S2, in the step of determining the preset parameters according to attribute parameters of the solar cell body 10 and a position parameter of the neutral plane S, the distance between the neutral plane S and the side of the protective layer 20 farther away from the neutral plane S, the thickness of the stress compensation layer 21, the Young's modulus of the stress compensation material for forming the stress compensation layer 21, the thickness of the substrate 11, the Young's modulus of the substrate material for forming the substrate 11, the thicknesses of the plurality of film layers 121, and the Young's moduli of the film layer materials for forming the plurality of film layers 121 satisfy: $h = \frac{{\sum }_{i = 1}^{n} {E}_{i} {t}_{i} \left[\left({\sum }_{j = 1}^{i} {t}_{j}\right)-\frac{{t}_{i}}{2}\right]}{{\sum }_{i = 1}^{n} {E}_{i} {t}_{i}}$ (1); where
h is the distance between the neutral plane S and the side of the protective layer 20 farther away from the neutral plane S, i is the i-th layer, n is the number of layers in the entire device structure, t is the thickness of each layer, E is the Young's modulus of the material of each layer, j is a variable, and j=1 indicates that j starts from 1.

The embodiments of this application provide a specific manner of determining the preset parameters of the protective layer 20. With the above method, the formed protective layer 20 matches the solar cell body 10. The neutral plane S of the solar cell 100 formed by the protective layer 20 and the solar cell body 10 is close to or located on the easily-failing functional layer 12, thereby reducing the failure risk of the functional layer 12, improving the bending resistance of the solar cell 100, and improving the service life of the solar cell 100. It can be understood that the embodiments of this application provide a specific method for determining the preset parameters of the protective layer 20, and other methods capable of determining the preset parameters of the protective layer 20 can also be used.

In any embodiment of this application, in the step of determining the preset parameters according to attribute parameters of the solar cell body 10 and a position parameter of the neutral plane S, the preset parameters further include a Poisson's ratio of the stress compensation material for forming the stress compensation layer 21, and the attribute parameters further include a Poisson's ratio of the substrate material for forming the substrate 11 and a Poisson's ratio of the film layer material for forming each film layer 121.

The distance between the neutral plane S and the side of the protective layer 20 farther away from the neutral plane S, the thickness of the stress compensation layer 21, the Young's modulus of the stress compensation material for forming the stress compensation layer 21, the Poisson's ratio of the stress compensation material for forming the stress compensation layer 21, the thickness of the substrate 11, the Young's modulus of the substrate material for forming the substrate 11, the Poisson's ratio of the substrate material for forming the substrate 11, the thicknesses of the plurality of film layers 121, the Young's modulus of the film layer material for forming each film layer 121, and the Poisson's ratio of the film layer material for forming each film layer 121 satisfy: $h = \frac{{\sum }_{i = 1}^{n} {\overline{E}}_{i} {t}_{i} \left[\left({\sum }_{j = 1}^{i} {t}_{j}\right)-\frac{{t}_{i}}{2}\right]}{{\sum }_{i = 1}^{n} {\overline{E}}_{i} {t}_{i}}$ (2); ${\overline{E}}_{i} = {E}_{i} \left(1-{ν}_{i}^{2}\right)$ (3); where
h is the distance between the neutral plane S and the side of the protective layer 20 farther away from the neutral plane S, i is the i-th layer, n is the number of layers in the entire device structure, t is the thickness of each layer, E is the Young's modulus of the material of each layer, j is a variable, j=1 indicates that j starts from 1, and v is the Poisson's ratio.

The embodiments of this application provide a specific manner of determining the preset parameters of the protective layer 20 considering the influence of lateral deformation of various structure layers on the position parameter of the neutral plane S. With the above method, the formed protective layer 20 matches the solar cell body 10. The neutral plane S of the solar cell 100 formed by the protective layer 20 and the solar cell body 10 is close to or located on the easily-failing functional layer 12, thereby reducing the failure risk of the functional layer 12, improving the bending resistance of the solar cell 100, and improving the service life of the solar cell 100.

The application of the above formulas is described by taking an example in which the protective layer 20 is disposed on the backlight side of the solar cell body 10 according to the preset parameters, and the protective layer 20 includes one stress compensation layer 21:

First, the solar cell body 10 includes a second electrode layer, a hole transport layer, a perovskite layer, an electron transport layer, a first electrode layer, and a substrate 11 that are sequentially stacked, and a protective layer 20 is disposed on a side of the second electrode layer farther away from the substrate, where the protective layer 20 includes only one stress compensation layer 21.

The thickness of the stress compensation layer 21 is t₁, a Young's modulus of a stress compensation material for forming the stress compensation layer 21 is E₁, and the Poisson's ratio thereof is ν₁. The above three parameters are all unknown quantities.

The thickness of the second electrode layer is t₂, and the film layer material for forming the second electrode layer has a Young's modulus of E₂ and a Poisson's ratio of v₂. The thickness of the hole transport layer is t₃, and the film layer material for forming the hole transport layer has a Young's modulus of E₃, and a Poisson's ratio of v₃. The thickness of the perovskite layer is t₄, and the film layer material for forming the perovskite layer has a Young's modulus of E₄, and a Poisson's ratio of v₄. The thickness of the electron transport layer is t₅, and the film layer material for forming the electron transport layer has a Young's modulus of E₅, and a Poisson's ratio of v₅. The thickness of the first electrode layer is t₆, and the film layer material for forming the first electrode layer has a Young's modulus of E₆, and a Poisson's ratio of v₆. The thickness of the substrate 11 is t₇, and the film layer material for forming the substrate 11 has a Young's modulus of E₇, and a Poisson's ratio of v₇. The above parameters are all known quantities.

To set the neutral plane S within the functional layer 12, the distance h between the neutral plane S and the side of the stress compensation layer 21 farther away from the substrate is between t₁ and t₁ + t₂ + t₃ + t₄ + t₅ + t₆.

One method is: first the thickness t₁ of the stress compensation layer 21 is determined, the thickness t₁ of the stress compensation layer 21 and the parameters of the substrate 11 and each film layer 121 of the solar cell body 10 are substituted into the above formulas to obtain the value ranges of the Young's modulus E₁ and Poisson's ratio ν₁ of the stress compensation material for forming the stress compensation layer 21, and then suitable stress compensation materials for forming the stress compensation layer 21 are screened according to the value ranges of the Young's modulus E₁ and Poisson's ratio ν₁ of the stress compensation material for forming the stress compensation layer 21. According to the above process, the preset parameters of the stress compensation layer 21 (including the thickness t₁ of the stress compensation layer 21, and the Young's modulus E₁ and the Poisson's ratio ν₁ of the stress compensation material for forming the stress compensation layer 21) are obtained.

Another method is: first the Young's modulus E₁ and Poisson's ratio ν₁ of the stress compensation material for forming the stress compensation layer 21 are determined, and the Young's modulus E₁ and Poisson's ratio ν₁ of the stress compensation material for forming the stress compensation layer 21 and the parameters of the substrate 11 and each film layer 121 of the solar cell body 10 are substituted into the above formulas to obtain the value range of the thickness t₁ of the stress compensation layer 21. According to the above process, the preset parameters of the stress compensation layer 21 (including the thickness t₁ of the stress compensation layer 21, and the Young's modulus E₁ and the Poisson's ratio ν₁ of the stress compensation material for forming the stress compensation layer 21) are obtained.

Referring to FIG. 11, FIG. 11 is a schematic structural diagram of an electric device according to an embodiment of this application.

Referring to FIG. 11, a third aspect of this application provides an electric device 1000, including a solar cell 100 prepared by any preparation method provided in the first aspect or any solar cell 100 provided in the second aspect.

In the embodiments of this application, the solar cell 100 serves as a power source for the electric device 1000 to achieve normal operation of the electric device 1000. The electric device 1000 adopts the solar cell 100 provided in this application, and has at least the same advantages as the solar cell 100, which can improve the battery performance of the electric device 1000. As an example, the electric device 1000 can include a lighting device, a display device, a new energy vehicle, or the like.

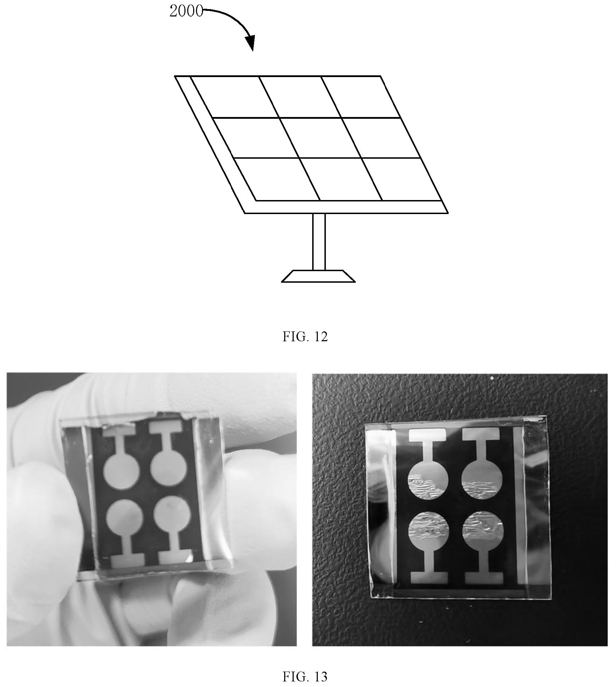

Referring to FIG. 12, FIG. 12 is a schematic structural diagram of a power generation device according to an embodiment of this application.

Referring to FIG. 12, a fourth aspect of this application provides a power generation device 2000, including a solar cell 100 prepared by any preparation method provided in the first aspect or any solar cell 100 provided in the second aspect.

In the embodiments of this application, the solar cell 100 serves as an energy source for the power generation device 2000 to achieve power output of the power generation device 2000. The power generation device 2000 adopts the solar cell 100 provided in this application, and has at least the same advantages as the solar cell 100, which can improve the power generation performance of the power generation device 2000. As an example, the power generation device 2000 can be applied in fields such as building power usage, wearable device power usage, smartphone power usage, and vehicle-mounted battery power usage.

The beneficial effects of this application are further illustrated below in conjunction with examples.

To make the technical problems solved, technical solutions, and beneficial effects of the embodiments of this application clearer, further detailed description will be made below in conjunction with examples and accompanying drawings. Obviously, the described examples are only some examples of this application, not all examples. Actually, the following description of at least one exemplary example is merely illustrative and in no way serves as any limitation on this application and its application. Based on the examples in this application, all other examples obtained by those of ordinary skill in the art without creative efforts shall fall within the protection scope of this application.

### Example 1

Preparation of solar cell 100, whose structural schematic diagram is shown in FIG. 7:
1. A solar cell body 10 was provided, and an initial position parameter of a neutral plane S was determined according to attribute parameters of the solar cell body 10.

The solar cell body 10 of this example included a substrate 11 and a plurality of film layers 121 that were sequentially stacked, the plurality of film layers 121 being sequentially a first electrode layer, an electron transport layer, a perovskite layer, a hole transport layer, and a second electrode layer.

The attribute parameters of the above substrate 11 and each film layer 121 were shown in Table 1. This example did not consider the lateral deformation of the substrate 11 and each film layer 121, that is, the Poisson's ratios of the substrate 11 and each film layer 121 in this example were all 0.

**Table 1 Attribute parameters of film layers of solar cell body**

| Item | Substrate | First electrode layer | Electron transport layer | Perovskite layer | Hole transport layer | Second electrode layer |
|---|---|---|---|---|---|---|
| Material | PET | ITO | C60 | Perovskite | BCP | Cu |
| Young's modulus (GPa) | 2*10⁶ | 170 | 12 | 18.5 | 12 | 128 |
| Thickness (nm) | 10⁵ | 200 | 20 | 600 | 10 | 100 |

| | | | | | | |
|---|---|---|---|---|---|---|
| Note: The example of this application temporarily does not consider lateral deformation of materials, and the Poisson's ratio is zero. PET is polyethylene terephthalate; ITO is indium tin oxide; the molecular formula of perovskite is FAPbI₃; C60 is fullerene C60; BCP is 2,9-dimethyl-4,7-diphenyl-1,10-phenanthroline; and Cu is copper. | | | | | | |

The parameters of the substrate 11 and each film layer 121 were substituted into the above formula (1) to yield a calculated initial position parameter of 5*10⁴ nm of the neutral plane S, which was close to the 1/2 position of the thickness of the substrate 11.

2. The position of the neutral plane S was adjusted, and the structure of the solar cell 100 was designed according to the structure shown in FIG. 7. The solar cell 100 included two stress compensation layers 21, one of which was a viscoelastic layer 211 and the other was an encapsulation layer 212. The encapsulation layer 212 and the viscoelastic layer 211 were sequentially disposed on a side of the solar cell body 10. Specifically, the viscoelastic layer 211 was disposed on a side of the functional layer 12 farther away from the substrate 11, and the encapsulation layer 212 was disposed on a side of the viscoelastic layer 211 farther away from the substrate 11. The material of the encapsulation layer 212 was preset as PET with a Young's modulus of 3×10⁶ GPa. The material of the viscoelastic layer 211 was preset as polyacrylate with a thickness of 10 µm and a Young's modulus of 50 kPa. This example did not consider lateral deformation of the protective layer 20, that is, the Poisson's ratios of the materials forming each layer of the protective layer 20 in this example were all 0.

The above parameters were substituted into the above formula (1) to yield a calculated thickness of 120 µm of the encapsulation layer 212, and the neutral plane S was located on the functional layer 12.

In addition, when the thickness range of the encapsulation layer 212 was within 97 µm to 141 µm, the effect of adjusting the position of the neutral plane S to be close to or located on the functional layer 12 can be well achieved. Specifically, when the thickness of the encapsulation layer 212 was 97 µm, the neutral plane S was located 10 µm below the functional layer 12. When the thickness of the encapsulation layer 212 was 141 µm, the neutral plane S was located 10 µm above the functional layer 12.

### Example 2

The difference between this example and Example 1 lies in that this example was designed according to the structure shown in FIG. 8. The protective layer 20 included a stress compensation body 201, a first bending portion 202, and a second bending portion 203. The stress compensation body 201 was disposed on the entire first surface 101, and the first surface 101 was the backlight surface of the solar cell body 10. The stress compensation body 201 of this example was formed by at least two stress compensation layers 21, one of which was a viscoelastic layer 211 and the other was an encapsulation layer 212. The viscoelastic layer 211 was disposed on a side of the functional layer 12 farther away from the substrate 11. The first bending portion 202 was formed by extending the encapsulation layer 212 forming the stress compensation body 201 and was disposed on the entire side surface 102. The second bending portion 203 was formed by extending the encapsulation layer 212 forming the first bending portion 202 and was disposed on the entire second surface 103.

The material of the encapsulation layer 212 was preset as PET with a Young's modulus of 3×10⁶ GPa. The material of the viscoelastic layer 211 was preset as polyacrylate with a thickness of 10 µm and a Young's modulus of 50 kPa. The material of the first bending portion 202 was preset as PET with a Young's modulus of 1×10⁶ GPa. The material of the second bending portion 203 was preset as PET with a Young's modulus of 2×10⁶ GPa and a thickness of 25 µm. The above parameters were substituted into the above formula (1) to yield a calculated thickness range of 90 µm of the encapsulation layer 212, and the neutral plane S was located on the functional layer 12.

### Example 3

The difference between this example and Example 1 lies in that this example was designed according to the structure shown in FIG. 10. The protective layer 20 was preset on both sides of the solar cell body 10, and the solar cell 100 included at least six stress compensation layers 21. Four of the stress compensation layers 21 were a first viscoelastic layer 2111, a high-elasticity layer 213, a second viscoelastic layer 2112, and a first encapsulation layer 2121 that were sequentially disposed on a side of the solar cell body 10, specifically on a side of the functional layer 12 farther away from the substrate 11. The first viscoelastic layer 2111 was bonded to the solar cell body 10. The other two stress compensation layers 21 were a third viscoelastic layer 2113 and a second encapsulation layer 2122 that were sequentially disposed on the other side of the solar cell body 10, and the third viscoelastic layer 2113 was bonded to the solar cell body 10.

The materials of the first encapsulation layer 2121 and the second encapsulation layer 2122 were both preset as PET. The thickness of the first encapsulation layer 2121 was preset as 25 µm, and the Young's modulus thereof was 3×10⁶ GPa. The thickness of the second encapsulation layer 2122 was 50 µm, and the Young's modulus thereof was 2×10⁶ GPa. Then, the materials of the first viscoelastic layer 2111, the second viscoelastic layer 2112, and the third viscoelastic layer 2113 were all preset as polyacrylate, each with a thickness of 10 µm and a Young's modulus of 50 kPa. The material of the high-elasticity layer 213 was preset as polyurethane with a Young's modulus of 1×10⁶ GPa.

The above parameters were substituted into the above formula (1) to yield a calculated thickness of 96 µm of the high-elasticity layer 213, thereby ensuring that the neutral plane S was located on the functional layer 12.

### Example 4

The difference between this example and Example 1 lies in that this example first preset the thickness of the encapsulation layer 212 as 80 µm and the material as PET. The material of the viscoelastic layer 211 was preset as polyacrylate with a thickness of 10 µm and a Young's modulus of 50 kPa. The position parameter of the neutral plane S was preset, that is, the distance between the neutral plane S and a side of the protective layer 20 farther away from the neutral plane S was 91 µm.

The above parameters were substituted into the above formula (1) to yield a calculated Young's modulus parameter of 1.25×10⁶ GPa of the encapsulation layer 212, thereby ensuring that the neutral plane S was located on the functional layer 12.

### Example 5

The difference between this example and Example 1 lies in that this example presets the material of the encapsulation layer 212 as PET with a Young's modulus of 1×10⁶ GPa. The above parameters were substituted into the above formula (1) to yield a calculated thickness of 72 µm of the encapsulation layer 212, and the neutral plane S was located on the functional layer 12.

In addition, when the thickness range of the encapsulation layer 212 was within 56 µm to 88 µm, the effect of adjusting the position of the neutral plane S to be close to or located on the functional layer 12 can be well achieved. Specifically, when the thickness of the encapsulation layer 212 was 56 µm, the neutral plane S was located 10 µm below the functional layer 12. When the thickness of the encapsulation layer 212 was 88 µm, the neutral plane S was located 10 µm above the functional layer 12.

### Comparative Example

The difference between this comparative example and Example 1 lies in that this comparative example did not provide a protective layer 20.

### Test method for bending performance:

The sensor position was adjusted to set the bending radius to 10 mm. The sample was fixed on the clamp table by clamping and fixing, the bending frequency was set to 3 bending cycles per second, and the number of bends was 10000. The bending operation mode was single-sided slide rail operation. The bending resistance was evaluated by testing the change in the battery's photoelectric conversion efficiency before and after bending.

### Test method for photoelectric conversion efficiency:

By changing the bias voltage point and performing current measurement, the I-V characteristics of the tested sample can be obtained.
(1) The test fixture containing the sample battery was placed on the sample holder so that it was on the measurement plane, and the sample battery was ensured to be at the center position of the emitted light spot of the solar simulator (or the normal of the photovoltaic battery was parallel to the centerline of the emitted beam of the solar simulator light source).
(2) A Guangyan solar simulator was used for testing, which complied with the national standard IEC61215. A crystalline silicon solar cell was used to calibrate the light intensity to reach one sun intensity. Under irradiation of 1000 W/m², the tested sample battery was fitted with a mask, and a temperature monitoring device was used to control the temperature of the sample battery so that during the measurement process, the temperature of the tested sample was maintained at (30±5)°C.
(3) The scanning direction, voltage range, scanning interval voltage, scanning interval time, and the like were set. The scanning interval was not greater than 0.02 V, and the interval time between adjacent points was not less than 0.3s. The forward and reverse sweep current-voltage characteristics of the tested sample battery were measured, and the open-circuit voltage V_{OC} and short-circuit current J_{SC} were recorded.

Calculation formula: Fill factor FF=Jₘ*Vₘ/V_{OC}*J_{SC}, where Jₘ was the maximum light output current and Vₘ was the maximum light output voltage. Energy conversion efficiency PCE=V_{OC}*J_{SC}*FF/Pᵢₙ. Pᵢₙ was the incident light intensity, which was equal to 10³ W/m² there.

**Table 2 Bending performance test results of solar cells in examples and comparative example of this application**

| Item | Percentage of initial photoelectric conversion efficiency retained after 10000 bends |
|---|---|
| Example 1 | >90% |
| Example 2 | >90% |
| Example 3 | >90% |
| Example 4 | >90% |
| Example 5 | >90% |
| Comparative Example 1 | <10% |

| | |
|---|---|
| Note: In the bending performance test of this application, the bending radius is set to 10 mm. | |

From Table 2, it can be seen that the examples of the present invention adjust the position of the neutral plane S to the functional layer 12 or close to the functional layer 12 by adding the protective layer 20, more than 90% of the initial photoelectric conversion efficiency can be retained after 10000 bends. When the neutral plane S is not adjusted (Comparative Example 1), the solar cell is severely damaged, and the retention rate of the initial photoelectric conversion efficiency after 10000 bends is less than 10%. FIG. 13 is a photograph of the solar cell 100 provided in Comparative Example 1 before and after the bending test, with the left figure taken before the bending test and the right figure taken after the bending test. It can be seen that the surface of the solar cell 100 is obviously damaged after the bending test.

In the several embodiments provided in this application, it should be understood that the disclosed systems, devices, and methods may be implemented in other ways. For example, the device embodiments described above are merely illustrative. For example, the division of units is only a logical functional division, and there may be other divisions in actual implementation. For example, multiple units or components may be combined or integrated into another system, or some features may be ignored or not executed. Another point is that the coupling or direct coupling or communication connection shown or discussed between each other may be indirect coupling or communication through some interfaces, devices or units, and may be electrical, mechanical or other forms.

In addition, each functional unit in various embodiments of this application may be integrated into one processing unit, or each unit may exist physically alone, or two or more units may be integrated into one unit. The above integrated units may be implemented in the form of hardware or in the form of software functional units.

The above descriptions are only embodiments of this application and do not limit the patent scope of this application. Any equivalent structures or equivalent process transformations or direct or indirect application in other related technical fields made by using the contents of the specification and drawings of this application shall all equally fall in the patent protection scope of this application.

## Claims

1. A solar cell, **characterized by** comprising:
a solar cell body comprising a substrate and a functional layer that are stacked; wherein the functional layer comprises a plurality of film layers that are stacked; and
a protective layer disposed on at least one side of the solar cell body along a stacking direction of the substrate and the functional layer, wherein the protective layer comprises at least one stress compensation layer; wherein
a neutral plane of the solar cell is located in the functional layer; or a neutral plane of the solar cell is located in the substrate, and a distance between a surface of the functional layer close to the substrate and the neutral plane is less than or equal to 10 µm; or a neutral plane of the solar cell is located in the protective layer, and a distance between a surface of the functional layer close to the protective layer and the neutral plane is less than or equal to 10 µm.

2. The solar cell according to claim 1, wherein the protective layer comprises a stress compensation body and a first bending portion, the first bending portion is formed by extending at least one stress compensation layer in the stress compensation body, the solar cell body comprises a first surface and a side surface surrounding the first surface, the first surface is one of a light receiving surface and a backlight surface of the solar cell body, the stress compensation body is disposed on the first surface, and the first bending portion is disposed on the side surface.

3. The solar cell according to claim 2, wherein the protective layer further comprises a second bending portion, the second bending portion is formed by extending at least one stress compensation layer in the first bending portion, the solar cell body further comprises a second surface disposed opposite to the first surface, the second surface is the other of the light receiving surface and the backlight surface of the solar cell body, and the second bending portion is disposed on the second surface.

4. The solar cell according to claim 3, wherein the second surface has a first region and a second region, the second bending portion is disposed on the second region of the second surface, and the solar cell further comprises another protective layer, wherein the another protective layer is disposed on the first region.

5. The solar cell according to claim 1, wherein the protective layer is disposed on both sides of the solar cell body, the protective layer comprises a stress compensation body and a bonding portion, the bonding portion is formed by extending at least one stress compensation layer in the stress compensation body, and a water-oxygen barrier adhesive is disposed between the two bonding portions.

6. The solar cell according to claim 5, wherein a gap is provided between the water-oxygen barrier adhesive and the solar cell body.

7. The solar cell according to claim 6, wherein a width of the gap is 0.1 cm to 1 cm.

8. The solar cell according to any one of claims 1 to 7, wherein the solar cell comprises at least two stress compensation layers, one of which is a viscoelastic layer and the other is an encapsulation layer, and the viscoelastic layer is located between the solar cell body and the encapsulation layer.

9. The solar cell according to any one of claims 1 to 7, wherein the solar cell comprises at least four stress compensation layers, the four stress compensation layers are a first viscoelastic layer, a high-elasticity layer, a second viscoelastic layer, and an encapsulation layer that are sequentially disposed, and the first viscoelastic layer farther away from the encapsulation layer is bonded to the solar cell body.

10. The solar cell according to claim 9, wherein a Young's modulus of the high-elasticity layer is 500 MPa to 5000 MPa.

11. The solar cell according to claim 9 or 10, wherein a thickness of the high-elasticity layer is 5 µm to 200 µm.

12. The solar cell according to any one of claims 9 to 11, wherein the high-elasticity layer comprises at least one of silicone and polyurethane elastomer.

13. The solar cell according to any one of claims 8 to 12, wherein at room temperature, the first viscoelastic layer has a Young's modulus of 10 kPa to 80 kPa, a creep strain of greater than or equal to 150%, and a creep recovery rate of greater than or equal to 90%; and/or the second viscoelastic layer has a Young's modulus of 10 kPa to 80 kPa, a creep strain of greater than or equal to 150%, and a creep recovery rate of greater than or equal to 90%.

14. The solar cell according to any one of claims 8 to 13, wherein a thickness of the first viscoelastic layer is 5 µm to 15 µm; and/or a thickness of the second viscoelastic layer is 5 µm to 15 µm.

15. The solar cell according to any one of claims 8 to 14, wherein the first viscoelastic layer comprises at least one of polyurethane and polyacrylate; and/or the second viscoelastic layer comprises at least one of polyurethane and polyacrylate.

16. The solar cell according to any one of claims 8 to 15, wherein the encapsulation layer comprises at least one of polyethylene terephthalate, polyethylene naphthalate, and polycarbonate.

17. The solar cell according to any one of claims 1 to 16, wherein the functional layer comprises a perovskite layer and a carrier transport layer, and the carrier transport layer is located on a side of the perovskite layer and configured to transport carriers.

18. The solar cell according to any one of claims 1 to 17, wherein the functional layer comprises a first electrode layer, a first carrier transport layer, a perovskite layer, a second carrier transport layer, and a second electrode layer that are sequentially stacked; the first electrode layer is disposed on the substrate and is a transparent conductive oxide thin film; and the first carrier transport layer is a hole transport layer and the second carrier transport layer is an electron transport layer, or the first carrier transport layer is an electron transport layer and the second carrier transport layer is a hole transport layer.

19. The solar cell according to any one of claims 1 to 18, wherein the functional layer comprises an all-perovskite tandem solar cell functional layer.

20. A method for preparing a solar cell, comprising:
providing a solar cell body, wherein the solar cell body comprises a substrate and a functional layer that are stacked; and the functional layer comprises a plurality of film layers that are stacked;
disposing a protective layer on at least one side of the solar cell body along a stacking direction of the substrate and the functional layer, wherein the protective layer comprises at least one stress compensation layer; wherein
a neutral plane of the solar cell is located in the functional layer; or a neutral plane of the solar cell is located in the substrate, and a distance between a surface of the functional layer close to the substrate and the neutral plane is less than or equal to 10 µm; or a neutral plane of the solar cell is located in the protective layer, and a distance between a surface of the functional layer close to the protective layer and the neutral plane is less than or equal to 10 µm.

21. The method for preparing a solar cell according to claim 20, wherein the step of disposing a protective layer on at least one side of the solar cell body comprises:
disposing the protective layer on at least one side of the solar cell body according to preset parameters, wherein the protective layer comprises at least one stress compensation layer, and the preset parameters comprise a thickness of each stress compensation layer and a Young's modulus of a stress compensation material for forming the stress compensation layer; wherein
the method for determining the preset parameters comprises:
determining the preset parameters according to attribute parameters of the solar cell body and a position parameter of the neutral plane, wherein the attribute parameters comprise a thickness of the substrate and a Young's modulus of a substrate material for forming the substrate, and a thickness of each film layer and a Young's modulus of a film layer material for forming the film layer, and the position parameter comprises a distance between the neutral plane and a side of the stress compensation layer farther away from the neutral plane.

22. The method for preparing a solar cell according to claim 21, wherein the preset parameters further comprise a Poisson's ratio of the stress compensation material for forming the stress compensation layer, and the attribute parameters further comprise a Poisson's ratio of the substrate material for forming the substrate and a Poisson's ratio of the film layer material for forming each film layer.

23. The method for preparing a solar cell according to any one of claims 20 to 22, wherein the protective layer comprises a stress compensation body and a first bending portion, the first bending portion is formed by extending a stress compensation layer in at least part of the stress compensation body, the solar cell body comprises a first surface and a side surface surrounding the first surface, the first surface is one of a light receiving surface and a backlight surface of the solar cell body, and the step of disposing the protective layer on at least one side of the solar cell body according to preset parameters comprises:
disposing the stress compensation body on the first surface according to the preset parameters, and
bending the first bending portion to the side surface; or
disposing the first bending portion on the side surface according to the preset parameters, and
bending the stress compensation body to the first surface.

24. The method for preparing a solar cell according to claim 23, wherein the protective layer further comprises a second bending portion, the second bending portion is formed by extending a stress compensation layer in at least part of the first bending portion, the solar cell body further comprises a second surface disposed opposite to the first surface, and the second surface is the other of the light receiving surface and the backlight surface of the solar cell body, wherein
after the step of bending the first bending portion to the side surface, further comprising: bending the second bending portion to the second surface; or
after the step of disposing the first bending portion on the side surface, further comprising: bending the second bending portion to the second surface; or
the step of disposing the first bending portion on the side surface is: disposing the second bending portion on the second surface, and bending the first bending portion to the side surface.

25. The method for preparing a solar cell according to any one of claims 20 to 22, wherein the protective layer is disposed on both sides of the solar cell body, the protective layer comprises a stress compensation body and a bonding portion, the bonding portion is formed by extending at least one stress compensation layer in the stress compensation body, the preset parameters comprise a first sub-preset parameter and a second sub-preset parameter, and the step of disposing the protective layer on at least one side of the solar cell body according to preset parameters comprises:
disposing one of the protective layers on one side of the solar cell body according to the first sub-preset parameter;
disposing the other of the protective layers on the other side of the solar cell body according to the second sub-preset parameter; and
disposing a water-oxygen barrier adhesive between the two bonding portions, wherein the first sub-preset parameter and the second sub-preset parameter are different.

26. The method for preparing a solar cell according to any one of claims 20 to 25, wherein in the step of determining the preset parameters according to attribute parameters of the solar cell body and a position parameter of the neutral plane, the distance between the neutral plane and the side of the protective layer farther away from the neutral plane, the thickness of the stress compensation layer, the Young's modulus of the stress compensation material for forming the stress compensation layer, the thickness of the substrate, the Young's modulus of the substrate material for forming the substrate, the thicknesses of the plurality of film layers, and the Young's moduli of the film layer materials for forming the plurality of film layers satisfy: $h = \frac{{\sum }_{i = 1}^{n} {E}_{i} {t}_{i} \left[\left({\sum }_{j = 1}^{i} {t}_{j}\right)-\frac{{t}_{i}}{2}\right]}{{\sum }_{i = 1}^{n} {E}_{i} {t}_{i}} ;$ wherein
h is the distance between the neutral plane and the side of the protective layer farther away from the neutral plane, i is the i-th layer, n is the number of layers in the entire device structure, t is the thickness of each layer, E is the Young's modulus of the material of each layer, j is a variable, and j=1 indicates that j starts from 1.

27. The method for preparing a solar cell according to claim 26, wherein in the step of determining the preset parameters according to attribute parameters of the solar cell body and a position parameter of the neutral plane,
the preset parameters further comprise a Poisson's ratio of the stress compensation material for forming the stress compensation layer, and the attribute parameters further comprise a Poisson's ratio of the substrate material for forming the substrate and a Poisson's ratio of the film layer material for forming each film layer; and
the distance between the neutral plane and the side of the protective layer farther away from the neutral plane, the thickness of the stress compensation layer, the Young's modulus of the stress compensation material for forming the stress compensation layer, the Poisson's ratio of the stress compensation material for forming the stress compensation layer, the thickness of the substrate, the Young's modulus of the substrate material for forming the substrate, the Poisson's ratio of the substrate material for forming the substrate, the thicknesses of the plurality of film layers, the Young's modulus of the film layer material for forming each film layer, and the Poisson's ratio of the film layer material for forming each film layer satisfy: $h = \frac{{\sum }_{i = 1}^{n} {\overline{E}}_{i} {t}_{i} \left[\left({\sum }_{j = 1}^{i} {t}_{j}\right)-\frac{{t}_{i}}{2}\right]}{{\sum }_{i = 1}^{n} {\overline{E}}_{i} {t}_{i}} ;$ ${\overline{E}}_{i} = {E}_{i} \left(1-{ν}_{i}^{2}\right) ;$ wherein
h is the distance between the neutral plane and the side of the protective layer farther away from the neutral plane, i is the i-th layer, n is the number of layers in the entire device structure, t is the thickness of each layer, E is the Young's modulus of the material of each layer, j is a variable, j=1 indicates that j starts from 1, and v is the Poisson's ratio.

28. An electric device comprising the solar cell according to any one of claims 1 to 19 or a solar cell prepared by the preparation method according to any one of claims 20 to 27.

29. A power generation device comprising the solar cell according to any one of claims 1 to 19 or a solar cell prepared by the preparation method according to any one of claims 20 to 27.
